# EUROPEAN PATENT APPLICATION

(11) **EP 4 554 351 A1**
(43) Date of publication of application: **14.05.2025**
(21) Application number: 24189438.5
(22) Date of filing: 18.07.2024
(51) Int. Cl.: H10B 43/30, H10B 43/27, H10B 43/40, H10B 43/35

(54) **SEMICONDUCTOR MEMORY DEVICE, METHOD FOR FABRICATING THE SAME AND ELECTRONIC SYSTEM INCLUDING THE SAME**

(30) Priority: 08.11.2023 KR 20230153592
(71) Applicant: Samsung Electronics Co., Ltd., Suwon-si, Gyeonggi-do 16677 (KR)
(72) Inventor: MOON, Joon, 16677 Suwon-si, Gyeonggi-do (KR); SON, Young Hwan, 16677 Suwon-si, Gyeonggi-do (KR); KANG, Shin Hwan, 16677 Suwon-si, Gyeonggi-do (KR); SUNG, Suk Kang, 16677 Suwon-si, Gyeonggi-do (KR)
(74) Representative: Kuhnen & Wacker Patent- und Rechtsanwaltsbüro PartG mbB

(57) **Abstract**

Semiconductor memory devices including memory cells arranged three-dimensionally, methods for fabricating the same, and electronic systems including the same are provided. The semiconductor memory device includes a first stacked structure including first gate electrodes sequentially stacked and spaced apart from each other, a second stacked structure on the first stacked structure and including second gate electrodes sequentially stacked and spaced apart from each other, and a channel structure extending in a vertical direction and passing through the first and second stacked structures, wherein the channel structure includes a channel layer including a first pillar portion crossing the first gate electrodes, a second pillar portion crossing the second gate electrodes, and a horizontal portion extending along a plane crossing the vertical direction, the horizontal portion connecting the first and second pillar portions, and a data storage layer extending along an outer side of the channel layer.

## Description

### CROSS-REFERENCE TO RELATED APPLICATION

This application claims priority from Korean Patent Application No. 10-2023-0153592 filed on November 8, 2023 in the Korean Intellectual Property Office and all the benefits accruing therefrom under 35 U.S.C. 119, the contents of which in its entirety are herein incorporated by reference.

### BACKGROUND

### Technical Field

The present disclosure relates to semiconductor memory devices, methods for fabricating the same, and electronic systems including the same, and more particularly, to semiconductor memory devices including memory cells arranged three-dimensionally, methods for fabricating the same, and electronic systems including the same.

### Description of the Related Art

As a semiconductor memory device capable of storing data of high capacity is required in an electronic system, methods capable of increasing data storage capacity of a semiconductor memory device have been studied. As one of methods capable of increasing data storage capacity of a semiconductor memory device, a semiconductor memory device including memory cells, which are arranged three-dimensionally instead of memory cells that are two-dimensionally, has been suggested.

### SUMMARY

Some example embodiments of the present disclosure provide semiconductor memory devices having improved reliability.

Some example embodiments of the present disclosure provide methods for fabricating a semiconductor memory device having improved reliability.

Some example embodiments of the present disclosure provide electronic systems including a semiconductor memory device having improved reliability.

Example embodiments of the present disclosure are not limited to those mentioned above and some example embodiments of the present disclosure, which are not mentioned herein, will be clearly understood by those skilled in the art from the following description of the present disclosure.

According to an example embodiment of the present inventive concepts, a semiconductor memory device includes a first stacked structure including a plurality of first gate electrodes sequentially stacked and spaced apart from each other, a second stacked structure on the first stacked structure, the second stacked structure including a plurality of second gate electrodes sequentially stacked and spaced apart from each other, and a channel structure extended in a vertical direction to pass through the first stacked structure and the second stacked structure, wherein the channel structure includes a channel layer including a first pillar portion crossing the plurality of first gate electrodes, a second pillar portion crossing the plurality of second gate electrodes, and a horizontal portion extended along a plane crossing the vertical direction, the horizontal portion connecting the first pillar portion and the second pillar portion, and a data storage layer extending along an outer side of the channel layer.

According to an example embodiment of the present inventive concepts, a semiconductor memory device includes a peripheral circuit structure including a peripheral circuit substrate and a peripheral circuit element on the peripheral circuit substrate, a first stacked structure on the peripheral circuit structure, the first stacked structure including a plurality of first gate electrodes sequentially stacked and spaced apart from each other, a second stacked structure between the peripheral circuit structure and the first stacked structure, the second stacked structure including a plurality of second gate electrodes sequentially stacked and spaced apart from each other, a channel layer extending in a vertical direction and passing through the first stacked structure and the second stacked structure, the channel layer including a first semiconductor layer crossing the plurality of first gate electrodes, and a second semiconductor layer crossing the plurality of second gate electrodes, a data storage layer including a first dielectric layer interposed between the first stacked structure and the first semiconductor layer and a second dielectric layer interposed between the second stacked structure and the second semiconductor layer, a source structure connected to the first semiconductor layer, on the first stacked structure, and a bit line connected to the second semiconductor layer and between the peripheral circuit structure and the second stacked structure, wherein a width of the first semiconductor layer is reduced as the first semiconductor layer is directed toward the second stacked structure, a width of the second semiconductor layer is reduced as the second semiconductor layer is directed toward the first stacked structure, and the second semiconductor layer includes a horizontal portion, the horizontal portion extending along a plane crossing the vertical direction and connected to the first semiconductor layer.

According to an example embodiment of the present inventive concept, an electronic system include a main board, a semiconductor memory device including a peripheral circuit structure and a cell structure that are sequentially stacked on the main board, and a controller on the main board and electrically connected to the semiconductor memory device, wherein the cell structure includes a first stacked structure including a plurality of first gate electrodes sequentially stacked and spaced apart from each other, a second stacked structure between the peripheral circuit structure and the first stacked structure, the second stacked structure including a plurality of second gate electrodes sequentially stacked and spaced apart from each other, and a channel structure extending in a vertical direction and passing through the first stacked structure and the second stacked structure, and wherein the channel structure includes a channel layer including a first pillar portion crossing the plurality of first gate electrodes, a second pillar portion crossing the plurality of second gate electrodes, and a horizontal portion extending along a plane crossing the vertical direction, the horizontal portion connecting the first pillar portion with the second pillar portion, and a data storage layer extending along an outer side of the channel layer.

### BRIEF DESCRIPTION OF THE DRAWINGS

The above and other aspects and features of the present inventive concepts will become more apparent by describing in detail some example embodiments thereof with reference to the attached drawings, in which:
FIG. 1 is a block diagram illustrating a semiconductor memory device according to an example embodiment.
FIG. 2 is a circuit view illustrating a semiconductor memory device according to an example embodiment.
FIG. 3 a layout view illustrating a semiconductor memory device according to an example embodiment.
FIG. 4 is a cross-sectional view taken along line A-A of FIG. 3.
FIG. 5 is an enlarged view illustrating a region R1 of FIG. 4.
FIG. 6 is FIG. 5 is an enlarged view illustrating a region R2 of FIG. 4.
FIG. 7 is an enlarged view illustrating a region R3 of FIG. 4.
FIG. 8 is a cross-sectional view illustrating a semiconductor memory device according to an example embodiment.
FIG. 9 is a cross-sectional view illustrating a semiconductor memory device according to an example embodiment.
FIG. 10 is a cross-sectional view illustrating a semiconductor memory device according to an example embodiment.
FIGS. 11 and 12 are various enlarged views illustrating a region R4 of FIG. 10.
FIG. 13 is a cross-sectional view illustrating a semiconductor memory device according to an example embodiment.
FIGS. 14 to 17 are various enlarged views illustrating a region R4 of FIG. 13.
FIGS. 18 to 34 are views illustrating intermediate steps to describe a method for fabricating a semiconductor memory device according to an example embodiment.
FIGS. 35 to 39 are views illustrating intermediate steps to describe a method for fabricating a semiconductor memory device according to an example embodiment.
FIGS. 40 to 42 are views illustrating intermediate steps to describe a method for fabricating a semiconductor memory device according to an example embodiment.
FIGS. 43 to 51 are views illustrating intermediate steps to describe a method for fabricating a semiconductor memory device according to some embodiments.
FIGS. 52 to 57 are views illustrating intermediate steps to describe a method for fabricating a semiconductor memory device according to an example embodiment.
FIG. 58 is a block diagram illustrating an electronic system according to an example embodiment.
FIG. 59 is an exemplary perspective view illustrating an electronic system according to an example embodiment.
FIG. 60 is a schematic cross-sectional view taken along line I-I of FIG. 59.

### DETAILED DESCRIPTION

It will be understood that, although the terms "first", "second", "upper portion", "lower portion", etc. may be used herein to describe various elements or components, these elements or components should not be limited by these terms. These terms are only used to distinguish one element or component from another element or component. Therefore, a first element or component discussed below could be termed a second element or component without departing from the technical spirits of the present disclosure.

As used herein, expressions such as "at least one of," when preceding a list of elements, modify the entire list of elements and do not modify the individual elements of the list. Thus, for example, both "at least one of A, B, or C" and "at least one of A, B, and C" mean either A, B, C or any combination thereof. Likewise, A and/or B means A, B, or A and B.

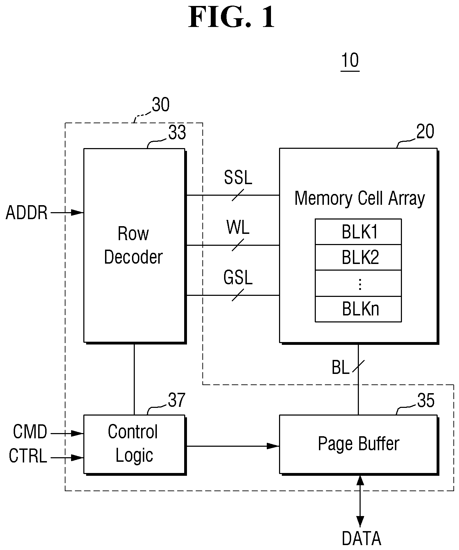

Hereinafter, a semiconductor memory device according to some example embodiments of the present disclosure will be described with reference to FIGS. 1 to 17.

FIG. 1 is a block diagram illustrating a semiconductor memory device 10 according to an example embodiment.

A memory cell array 20 may include a plurality of memory cell blocks BLK1 to BLKn. Each of the memory cell blocks BLK1 to BLKn may include a plurality of memory cells. The memory cell array 20 may be connected to a peripheral circuit 30 through a bit line BL, a word line WL, at least one string selection line SSL and at least one ground selection line GSL. For example, the memory cell blocks BLK1 to BLKn may be connected to a row decoder 33 through the word line WL, the string selection line SSL and the ground selection line GSL. In addition, the memory cell blocks BLK1 to BLKn may be connected to a page buffer 35 through the bit line BL.

The peripheral circuit 30 may receive an address ADDR, a command CMD and a control signal CTRL from the outside of the semiconductor memory device 10, and may transmit and receive data DATA to and from an external device of the semiconductor memory device 10. The peripheral circuit 30 may include a control logic 37, a row decoder 33 and a page buffer 35. Although not shown, the peripheral circuit 30 may further include various subcircuits such as an input/output circuit, a voltage generating circuit for generating various voltages for an operation of the semiconductor memory device 10 and an error correction circuit for correcting an error of data DATA read from the memory cell array 20.

The control logic 37 may be connected to the row decoder 33, the input/output circuit and the voltage generating circuit. The control logic 37 may control the overall operation of the semiconductor memory device 10. The control logic 37 may generate various internal control signals used in the semiconductor memory device 10 in response to the control signal CTRL. For example, the control logic 37 may adjust a voltage level provided to the word line WL and the bit line BL when a memory operation such as a program operation or an erase operation is performed.

The row decoder 33 may select at least one of the plurality of memory cell blocks BLK1 to BLKn in response to the address ADDR, and may select at least one word line WL, at least one string selection line SSL and at least one ground selection line GSL of the selected memory cell blocks BLK1 to BLKn. In addition, the row decoder 33 may transfer a voltage for performing the memory operation to the word line WL of the selected memory cell blocks BLK1 to BLKn.

The page buffer 35 may be connected to the memory cell array 20 through the bit line BL. The page buffer 35 may operate as a write driver or a sense amplifier. For example, when a program operation is performed, the page buffer 35 may operate as a write driver to apply a voltage according to the data DATA to be stored in the memory cell array 20, to the bit line BL. Meanwhile, when a read operation is performed, the page buffer 35 may operate as a sense amplifier to sense the data DATA stored in the memory cell array 20.

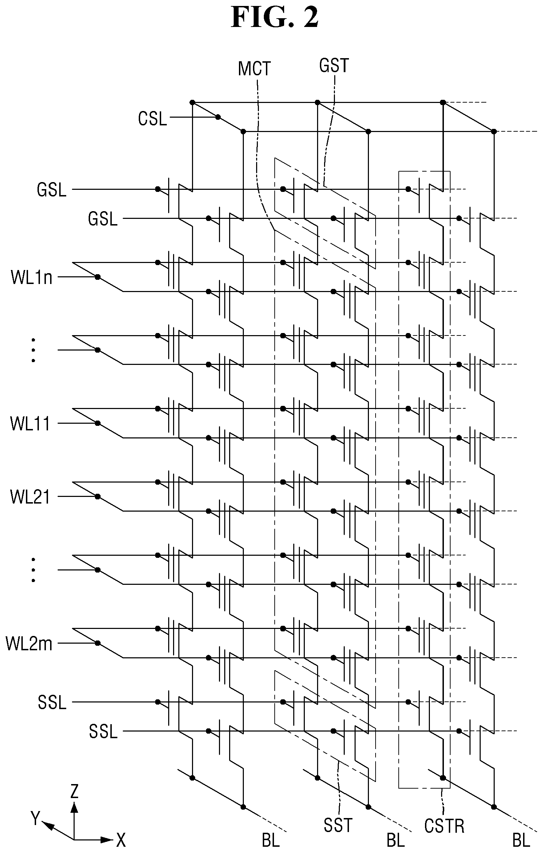

FIG. 2 is a circuit view illustrating a semiconductor memory device according to an example embodiment.

Referring to FIG. 2, a memory cell array (e.g., 20 of FIG. 1) of a semiconductor memory device according to semiconductor memory device includes a common source line CSL, a plurality of bit lines BL and a plurality of cell strings CSTR.

The plurality of bit lines BL may be arranged two-dimensionally on a plane including a first direction X and a second direction Y. For example, the bit lines BL may be respectively extended in the second direction Y, and may be spaced apart from each other and then arranged along the first direction X. The plurality of cell strings CSTR may be respectively connected to the respective bit lines BL in parallel. The cell strings CSTR may be commonly connected to the common source line CSL. That is, the plurality of cell strings CSTR may be disposed between the bit lines BL and the common source line CSL.

Each of the cell strings CSTR may include a ground selection transistor GST connected to the common source line CSL, a string selection transistor SST connected to the bit line BL and a plurality of memory cell transistors MCT disposed between the ground selection transistor GST and the string selection transistor SST. Each of the memory cell transistors MCT may include a data storage element. The ground selection transistor GST, the string selection transistor SST and the memory cell transistors MCT may be connected in series in a vertical direction (hereinafter, referred to as a third direction Z) crossing the first direction X and the second direction Y.

The common source line CSL may be commonly connected to sources of the ground selection transistors GST. In addition, the ground selection line GSL, a plurality of word lines WL11 to WL1ₙ and WL21 to WL2m and the string selection line SSL may be disposed between the common source line CSL and the bit line BL. The ground selection line GSL may be used as a gate electrode of the ground selection transistor GST, the word lines WL11 to WL1ₙ may be used as gate electrodes of the memory cell transistors MCT, and the string selection line SSL may be used as a gate electrode of the string selection transistor SST.

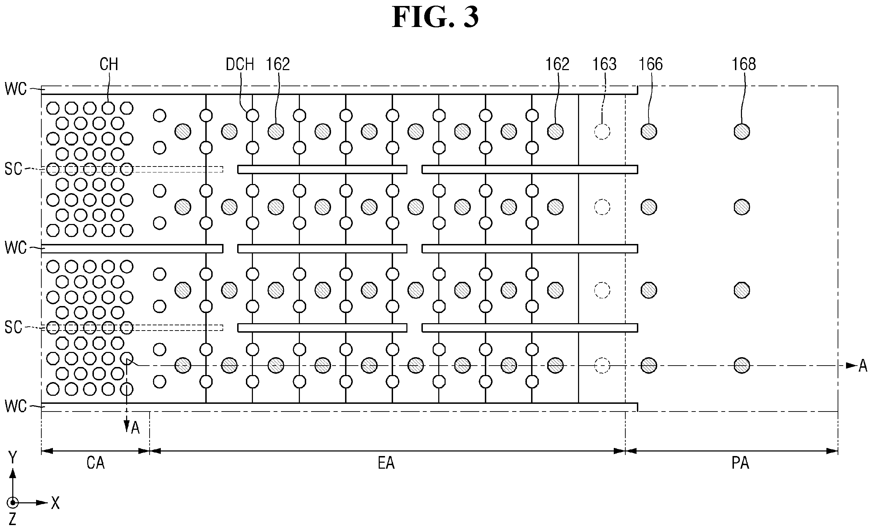

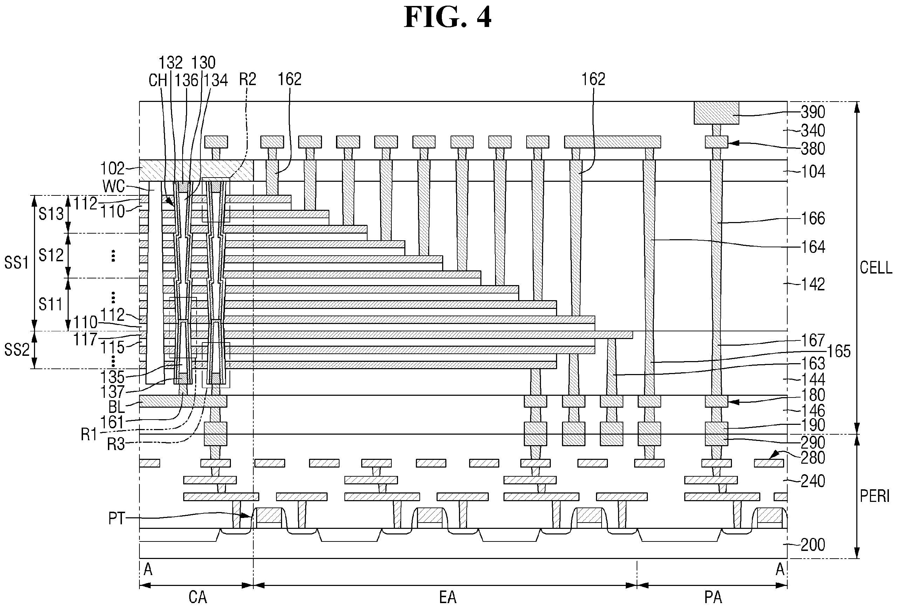

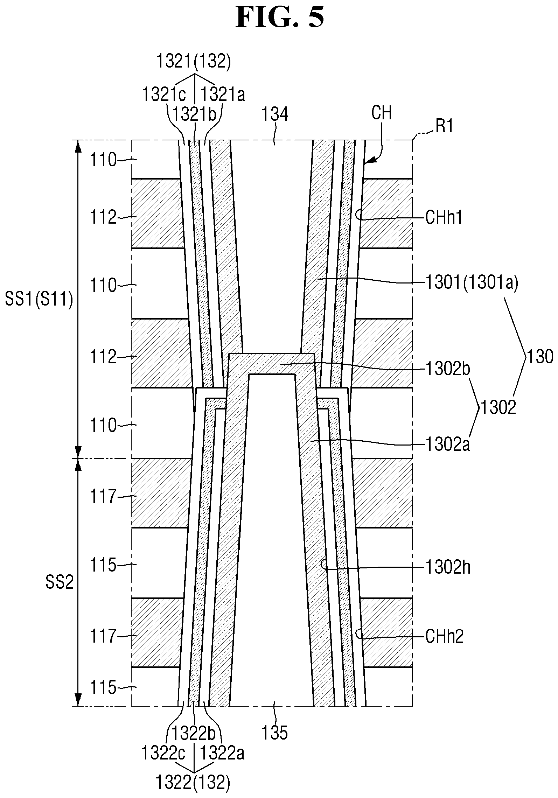

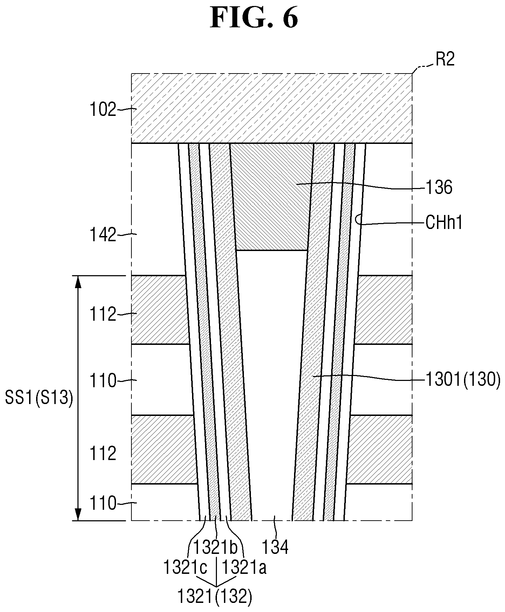

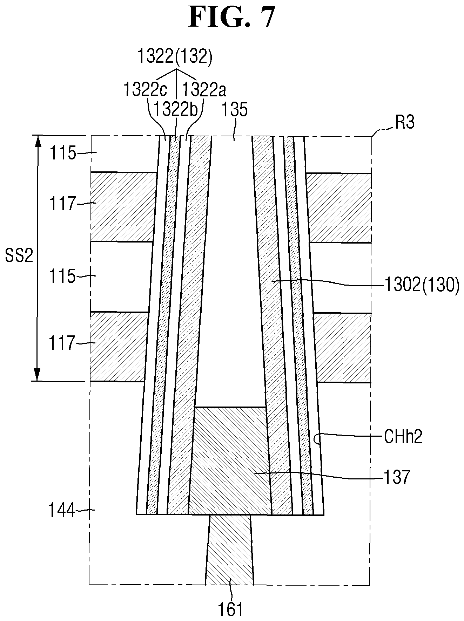

FIG. 3 is a layout view illustrating a semiconductor memory device according to semiconductor memory device. FIG. 4 is a cross-sectional view taken along line A-A of FIG. 3. FIG. 5 is an enlarged view illustrating a region R1 of FIG. 4. FIG. 6 is an enlarged view illustrating a region R2 of FIG. 4. FIG. 7 is an enlarged view illustrating a region R3 of FIG. 4.

Referring to FIGS. 3 to 7, the semiconductor memory device according to an example embodiment includes a memory cell structure CELL and a peripheral circuit structure PERI.

The memory cell structure CELL may include a cell array area CA, an extension area EA and an external area PA.

A memory cell array (e.g., 20 of FIG. 1) including a plurality of memory cells may be formed in the cell array area CA. For example, a source structure 102, a channel structure CH, gate electrodes 112 and 117 and a bit line BL, which will be described later, may be disposed on the cell array area CA.

The extension area EA may be disposed near the cell array area CA. For example, the extension area EA may be adjacent to the cell array area CA in the first direction X. The gate electrodes 112 and 117, which will be described later, may be stacked on the extension area EA in a stepwise shape.

The external area PA may be a peripheral area surrounding the cell array area CA and the extension area EA. For example, the external area PA may be adjacent to the cell array area CA and/or the extension area EA in the first direction X and the second direction Y. A conductive pad 390, which will be described later, may be disposed in the external area PA.

The memory cell structure CELL may include a source structure 102, a first stacked structure SS1, a first interlayer insulating layer 142, a second stacked structure SS2, a second interlayer insulating layer 144, a channel structure CH, a cutting structure WC, a first gate contact 162, a second gate contact 163, a first cell wiring structure 380, a second cell wiring structure 180, first through vias 164 and 165, second through vias 166 and 167, and a conductive pad 390.

The first stacked structure SS1 may be disposed in the cell array area CA and the extension area EA. The first stacked structure SS1 may include a plurality of first mold insulating layers 110 and a plurality of first gate electrodes 112 that are alternately stacked along the third direction Z. Each of the first mold insulating layers 110 and each of the first gate electrodes 112 may have a layered structure extended along a plane (e.g., XY plane) crossing the third direction Z. The first gate electrodes 112 may be sequentially stacked along the third direction Z by being spaced apart from each other by the first mold insulating layers 110. The number and shape of the first mold insulating layers 110 and the first gate electrodes 112are not limited to the shown example.

The first interlayer insulating layer 142 may cover the first stacked structure SS1. The first interlayer insulating layer 142 may include at least one of, for example, silicon oxide, silicon oxynitride or a low-k material having a dielectric constant lower than that of silicon oxide, but is not limited thereto.

The second stacked structure SS2 may be disposed in the cell array area CA and the extension area EA. The second stacked structure SS2 may be stacked on the first stacked structure SS1. For example, the second stacked structure SS2 may be formed on a lower surface of the first stacked structure SS1 and a lower surface of the first interlayer insulating layer 142. The second stacked structure SS2 may include a plurality of second mold insulating layers 115 and a plurality of second gate electrodes 117 that are alternately stacked along the third direction Z. Each of the second mold insulating layers 115 and each of the second gate electrodes 117 may have a layered structure extended along a plane (e.g., XY plane) crossing the third direction Z. The second gate electrodes 117 may be sequentially stacked along the third direction Z by being spaced apart from each other by the second mold insulating layers 115. The number and shape of the second mold insulating layers 115 and the second gate electrodes 117 are not limited to the shown example.

The second interlayer insulating layer 144 may cover the second stacked structure SS2. For example, the second interlayer insulating layer 144 may be formed on the lower surface of the first stacked structure SS1 and the lower surface of the first interlayer insulating layer 142. The second interlayer insulating layer 144 may include at least one of, for example, silicon oxide, silicon oxynitride or a low-k material having a dielectric constant lower than that of silicon oxide, but is not limited thereto.

In some example embodiments, the first gate electrodes 112 may include a plurality of first word lines (e.g., WL11 to WL1ₙ of FIG. 2) and a ground selection line (e.g., GSL of FIG. 2), which are sequentially stacked on an upper surface of the second stacked structure SS2.

In some example embodiments, the second gate electrodes 117 may include a plurality of second word lines (e.g., WL21 to WL2m of FIG. 2) and a string selection line (e.g., SSL of FIG. 2), which are sequentially stacked on the lower surface of the first stacked structure SS1.

The gate electrodes 112 and 117 may include a conductive material, for example, a semiconductor material such as silicon or metal (e.g., tungsten (W), molybdenum (Mo), ruthenium (Ru), cobalt (Co), or nickel (Ni)), but is not limited thereto. For example, each of the gate electrodes 112, 117 may include at least one of tungsten (W), molybdenum (Mo) or ruthenium (Ru). For another example, each of the gate electrodes 112 and 117 may include polysilicon.

The mold insulating layers 110 and 115 may include at least one of, for example, silicon oxide, silicon nitride or silicon oxynitride, but is not limited thereto. For example, each of the mold insulating layers 110 and 115 may include a silicon oxide layer.

In some example embodiments, the first stacked structure SS1 may include a plurality of stacks S11, S12 and S13. For example, the first stacked structure SS1 may include a first stack S11, a second stack S12 and a third stack S13, which are sequentially stacked on the upper surface of the second stacked structure SS2. The stacks S11, S12 and S13 of the first stacked structure SS1 may include a plurality of first mold insulating layers 110 and a plurality of first gate electrodes 112 that are alternately stacked. Although three stacks S11, S12 and S13 stacked on the second stacked structure SS2 are shown, this is only an example, and the number of stacks S11, S12 and S13 may vary.

The channel structure CH may be disposed in the cell array area CA. The channel structure CH may be extended in the third direction Z to pass through the first stacked structure SS1 and the second stacked structure SS2. For example, the channel structure CH may be a pillar type (e.g., cylindrical) structure extended in the third direction Z. The channel structure CH may cross the plurality of gate electrodes 112 and 117.

In some example embodiments, the plurality of channel structures CH may be arranged in a zigzag form. For example, as shown in FIG. 3, the plurality of channel structures CH may be arranged to alternate with each other in the first direction X and the second direction Y. Such channel structures CH may further improve the degree of integration of the semiconductor memory device. The number and arrangement of the channel structures CH are not limited to the shown example.

In some example embodiments, the channel structure CH may have a tapered shape toward the second stacked structure SS2 in each of the stacks S11, S12 and S13 of the first stacked structure SS1. For example, as shown in FIG. 4, in each of the stacks S11, S12 and S13 of the first stacked structure SS1, a width of the channel structure CH may be reduced as the channel structure is directed toward the second stacked structure SS2. This may result from that an etching process for forming the channel structure CH with respect to the respective stacks S11, S12 and S13 of the first stacked structure SS1 is performed in a direction (e.g., -Z direction) directed toward the second stacked structure SS2.

In some example embodiments, the channel structure CH may have a step difference between the stacks S11, S12 and S13 of the first stacked structure SS1. For example, in a boundary surface between the first stack S11 and the second stack S12, a width of an upper portion of the channel structure CH in the first stack S11 may be greater than that of a lower portion of the channel structure CH in the second stack S12. Furthermore, in a boundary surface between the second stack S12 and the third stack S13, a width of the upper portion of the channel structure CH in the second stack S12 may be greater than that of the lower portion of the channel structure CH in the third stack S13.

The channel structure CH may have a structure in which a portion in the first stacked structure SS1 and a portion in the second stacked structure SS2 are bonded to each other. For example, a first channel hole CHh1 extended in the third direction Z to pass through the first stacked structure SS1 may be formed. The channel structure CH in the first stacked structure SS1 may be formed in the first channel hole CHh1. In addition, a second channel hole CHh2 extended in the third direction Z to pass through the second stacked structure SS2 and expose the channel structure CH in the first stacked structure SS1 may be formed. The channel structure CH in the second stacked structure SS2 may be formed in the second channel hole CHh2 so that it may be bonded to the channel structure CH in the first stacked structure SS1.

The channel structure CH may include a channel layer 130, a data storage layer 132, a first filling insulating layer 134, a second filling insulating layer 135, a first channel pad 136, and a second channel pad 137.

The channel layer 130 may be extended in the third direction Z to pass through the first stacked structure SS1 and the second stacked structure SS2. The channel layer 130 may include a first semiconductor layer 1301 and a second semiconductor layer 1302. The first semiconductor layer 1301 may cross the plurality of first gate electrodes 112. The second semiconductor layer 1302 may cross the plurality of second gate electrodes 117. The first semiconductor layer 1301 and the second semiconductor layer 1302 may be connected to each other.

In some example embodiments, the first semiconductor layer 1301 may have a tapered shape toward the second stacked structure SS2 in each of the stacks S 11, S12 and S13 of the first stacked structure SS1. For example, as shown in FIG. 5, a width of the first semiconductor layer 1301 may be reduced as the first semiconductor layer 1301 is directed toward the second stacked structure SS2. This may result from that an etching process for forming the first channel hole CHh1 with respect to the respective stacks S11, S12 and S13 of the first stacked structure SS1 is performed in a direction (e.g., -Z direction) directed toward the second stacked structure SS2.

In some example embodiments, the second semiconductor layer 1302 may have a tapered shape toward the first stacked structure SS1. For example, as shown in FIG. 5, a width of the second semiconductor layer 1302 may be reduced as the second semiconductor layer 1302 is directed toward the second stacked structure SS2. This may result from the fact that an etching process for forming the second channel hole CHh2 with respect to the second stacked structure SS2 is performed in a direction (for example, Z direction) directed toward the first stacked structure SS1.

The first semiconductor layer 1301 and the second semiconductor layer 1302 may include, for example, a semiconductor material such as monocrystalline silicon, polycrystalline silicon (polysilicon), an organic semiconductor material, or a carbon nanostructure, but is not limited thereto. Although a boundary between the first semiconductor layer 1301 and the second semiconductor layer 1302 is shown in FIGS. 4 and 5, this is only an example, and the boundary between the first semiconductor layer 1301 and the second semiconductor layer 1302 may not exist.

In some example embodiments, the first semiconductor layer 1301 may include a first pillar portion 1301a. The first pillar portion 1301a may be extended in the third direction Z to cross the plurality of first gate electrodes 112. For example, the first pillar portion 1301a may be a cylindrical shape extended in the third direction Z.

In some example embodiments, the second semiconductor layer 1302 may include a second pillar portion 1302a and a first horizontal portion 1302b. The second pillar portion 1302a may be extended in the third direction Z to cross the plurality of second gate electrodes 117. For example, the second pillar portion 1302a may be a cylindrical shape extended in the third direction Z. The first horizontal portion 1302b may be extended from an upper portion of the second pillar portion 1302a along a plane (e.g., XY plane) crossing the third direction Z. For example, the first horizontal portion 1302b may be a plate shape (e.g., circular plate shape) for blocking or closing an upper portion of the cylindrical second pillar portion 1302a having a cylindrical shape. That is, the second semiconductor layer 1302 including the second pillar portion 1302a and the first horizontal portion 1302b may have a cup shape. The first horizontal portion 1302b may be connected to the first semiconductor layer 1301. For example, an upper surface of the first horizontal portion 1302b may be protruded upward from a lowermost surface of the first pillar portion 1301a. Therefore, the second semiconductor layer 1302 may be bonded to the first semiconductor layer 1301.

The data storage layer 132 may be interposed between the stacked structures SS1 and SS2 and the channel layer 130. For example, the data storage layer 132 may be extended along an outer side of the channel layer 130. The data storage layer 132 may include a first dielectric layer 1321 and a second dielectric layer 1322. The first dielectric layer 1321 may be interposed between the first semiconductor layer 1301 and the first stacked structure SS1. For example, the first dielectric layer 1321 may be extended to be conformal along a profile of the first channel hole CHh1, and the first semiconductor layer 1301 may be extended to be conformal on the first dielectric layer 1321. The second dielectric layer 1322 may be interposed between the second semiconductor layer 1302 and the second stacked structure SS2. For example, the second dielectric layer 1322 may be extended to be conformal along a profile of the second channel hole CHh2, and the second semiconductor layer 1302 may be extended to be conformal on the second dielectric layer 1322.

The second semiconductor layer 1302 may be connected to the first semiconductor layer 1301 by passing through the second dielectric layer1322. For example, a connection hole 1302h extended in the third direction Z to pass through an upper portion of the second dielectric layer 1322 and expose a lower portion of the first semiconductor layer 1301 may be formed. The second semiconductor layer 1302 may be formed in the connection hole 1302h and thus bonded to the first semiconductor layer 1301. Therefore, the channel layer 130 may have a structure in which the first semiconductor layer 1301 and the second semiconductor layer 1302 are bonded to each other.

Each of the first dielectric layer 1321 and the second dielectric layer 1322 may include at least one of silicon oxide, silicon nitride, silicon oxynitride or a high-k material having a dielectric constant higher than that of silicon oxide. The high-k material may include at least one of, for example, aluminum oxide, hafnium oxide, lanthanum oxide, tantalum oxide, titanium oxide, lanthanum hafnium oxide, lanthanum aluminum oxide, dysprosium scandium oxide or combination thereof.

In some example embodiments, each of the first dielectric layer 1321 and the second dielectric layer 1322 may be formed of a multi-layer. For example, the first dielectric layer 1321 may include a first tunneling insulating layer 1321a, a first charge storage layer 1321b and a first blocking insulating layer 1321c, which are sequentially stacked on the outer side of the first semiconductor layer 1301. For example, the second dielectric layer 1322 may include a second tunneling insulating layer 1322a, a second charge storage layer 1322b, and a second blocking insulating layer 1322c, which are sequentially stacked on the outer side of the second semiconductor layer 1302.

Each of the first tunneling insulating layer 1321a and the second tunneling insulating layer 1322a may include, for example, silicon oxide or a high-k material (e.g., aluminum oxide (Al₂O₃) or hafnium oxide (HfO₂)) having a dielectric constant higher than that of the silicon oxide. Each of the first charge storage layer 1321b and the second charge storage layer 1322b may include, for example, silicon nitride. Each of the first blocking insulating layer 1321c and the second blocking insulating layer 1322c may include, for example, silicon oxide or a high-k material (e.g., aluminum oxide (Al₂O₃) or hafnium oxide (HfO₂)) having a dielectric constant higher than that of the silicon oxide.

In some example embodiments, an upper portion of the second dielectric layer 1322 may protrude upward from a boundary surface between the first stacked structure SS1 and the second stacked structure SS2. For example, an upper surface of the second blocking insulating layer 1322c may be formed to be higher than the boundary surface between the first stacked structure SS1 and the second stacked structure SS2.

In some example embodiments, the first charge storage layer 1321b and the second charge storage layer 1322b may be separated from each other. For example, as shown in FIG. 5, an upper portion of the second blocking insulating layer 1322c may be extended along a plane (e.g., XY plane) crossing the third direction Z. In this case, the first charge storage layer 1321b and the second charge storage layer 1322b may be separated from each other by the second blocking insulating layer 1322c. In some example embodiments, an upper portion of the second charge storage layer 1322b may be extended along a plane (e.g., XY plane) crossing the third direction Z.

The first filling insulating layer 134 may be formed to fill at least a portion of the inside of the first semiconductor layer 1301. For example, the first filling insulating layer 134 may fill at least a portion of an area of the first channel hole CHh1, which remains after the first dielectric layer 1321 and the first semiconductor layer 1301 are filled. The first filling insulating layer 134 may include, for example, silicon oxide, but is not limited thereto.

The second filling insulating layer 135 may be formed to fill at least a portion of the inside of the second semiconductor layer 1302. For example, the second filling insulating layer 135 may fill at least a portion of an area of the second channel hole CHh2, which remains after the second dielectric layer 1322 and the second semiconductor layer 1302 are filled. The second filling insulating layer 135 may include, for example, silicon oxide, but is not limited thereto.

In some example embodiments, the first filling insulating layer 134 and the second filling insulating layer 135 may be separated by the first horizontal portion 1302b. For example, the first horizontal portion 1302b may be extended along a plane (e.g., XY plane) crossing the third direction Z between the first filling insulating layer 134 and the second filling insulating layer 135.

The first channel pad 136 may be connected to one end of the channel layer 130. For example, as shown in FIG. 6, the first channel pad 136 may be formed on the first filling insulating layer 134 and thus connected to an upper portion of the first semiconductor layer 1301. Although only the first channel pad 136 is shown as being in contact with an inner side of the first semiconductor layer 1301, this is merely an example, and the first channel pad 136 may be in contact with the upper surface of the first semiconductor layer 1301. The first channel pad 136 may include a conductive material, for example, polysilicon doped with impurities or metal, but is not limited thereto. In some example embodiments, the first channel pad 136 may be omitted.

The second channel pad 137 may be connected to the other end of the channel layer 130. For example, as shown in FIG. 7, the second channel pad 137 may be formed below the second filling insulating layer 135 and thus connected to a lower portion of the second semiconductor layer 1302. Although the second channel pad 137 is shown as being in contact with the inner side of the second semiconductor layer 1302, this is merely an example, and the second channel pad 137 may be in contact with a lower surface of the second semiconductor layer 1302. The second channel pad 137 may include a conductive material, for example, polysilicon doped with impurities or metal, but is not limited thereto. In some embodiments, the second channel pad 137 may be omitted.

In some example embodiments, a dummy channel structure DCH may be formed in the extension area EA. The dummy channel structure DCH may be extended in the third direction Z to pass through at least a portion of the first stacked structure SS1 and/or at least a portion of the second stacked structure SS2.

The dummy channel structure DCH may be formed at the same level as the channel structure CH, or may be formed at a different level from the channel structure CH. For example, when the dummy channel structure DCH is formed at the same level as the channel structure CH, the dummy channel structure DCH may include the channel layer 130, the data storage layer 132, the first filling insulating layer 134, the second filling insulating layer 135, the first channel pad 136 and the second channel pad 137, which are described as above. For another example, when the dummy channel structure DCH is formed at the level different from that of the channel structure CH, the dummy channel structure DCH may be filled with an insulating material and/or a conductive material. A size of the dummy channel structure DCH may be the same as that of the channel structure CH, or may be different from that of the channel structure CH. In some example embodiments, the size of the dummy channel structure DCH may be greater than that of the channel structure CH.

The cutting structure WC may be extended in the first direction X to cut the first stacked structure SS1 and the second stacked structure SS2. In addition, the plurality of cutting structures WC may be spaced apart from each other and extended in parallel with each other in the first direction X. The first stacked structure SS1 and the second stacked structure SS2 may be divided by the plurality of cutting structures WC to form a plurality of memory cell blocks (e.g., BLK1 to BLKn in FIG. 1). For example, two adjacent cutting structures WC may define one memory cell block therebetween. A plurality of channel structures CH may be disposed in each of the memory cell blocks defined by the cutting structures WC.

In some example embodiments, the cutting structure WC may include an insulating material. For example, the cutting structure WC may include at least one of silicon oxide, silicon nitride or silicon oxynitride, but is not limited thereto.

In some example embodiments, a string separation pattern SC may be formed in the second stacked structure SS2. The string separation pattern SC may be extended in the first direction X to cut a string selection line (SSL of FIG. 2; for example, a gate electrode disposed at a lowermost portion of the second gate electrodes 117) of the second stacked structure SS2. Each of the memory cell blocks defined by the cutting structures WC may be divided by the string separation pattern SC to form a plurality of string areas. For example, the string separation pattern SC may define two string areas in one memory cell block. The string separation pattern SC may include at least one of an insulating material, for example, silicon oxide, silicon nitride or silicon oxynitride, but is not limited thereto.

The source structure 102 may be disposed in the cell array area CA. The source structure 102 may be stacked on the first stacked structure SS1. For example, the source structure 102 may be formed on the upper surface of the first interlayer insulating layer 142 of the cell array area CA. The source structure 102 may be connected to one end of the channel layer 130. For example, as shown in FIG. 6, the source structure 102 may be in contact with an upper end of the first semiconductor layer 1301 and/or the first channel pad 136.

The source structure 102 may include a conductive material, for example, polysilicon doped with impurities, metal or metal silicide, but is not limited thereto. For example, the source structure 102 may include polysilicon (poly-Si) doped with n-type impurities (e.g., phosphorus (P) or arsenic (As)). The source structure 102 may be provided as a common source line (e.g., CSL of FIG. 2) of the semiconductor memory device according to some example embodiments.

In some example embodiments, a third interlayer insulating layer 104 may be formed near the source structure 102. The third interlayer insulating layer 104 may form an insulating area near the source structure 102 over the extension area EA and the external area PA. For example, the third interlayer insulating layer 104 may be formed on the upper surface of the first interlayer insulating layer 142 of the extension area EA and the external area PA. The third interlayer insulating layer 104 may include at least one of, for example, silicon oxide, silicon oxynitride or a low-k material having a dielectric constant lower than that of silicon oxide, but is not limited thereto.

The first gate contact 162 may be disposed in the extension area EA. The first gate contact 162 may be connected to the first gate electrodes 112. For example, the first gate electrodes 112 of the extension area EA may be stacked on the upper surface of the second stacked structure SS2 in a stepwise shape. Each of the plurality of first gate contacts 162 may be extended in the third direction Z to pass through the third interlayer dielectric layer 104 and the first interlayer dielectric layer 142, and may be connected to the first gate electrodes 112 corresponding thereto in the extension area EA. In some example embodiments, a width of the first gate contact 162 may be reduced as the first gate contact 162 is directed toward the second interlayer insulating layer 144.

The second gate contact 163 may be disposed in the extension area EA. The second gate contact 163 may be connected to the second gate electrodes 117. For example, the second gate electrodes 117 of the extension area EA may be stacked on the lower surface of the first stacked structure SS1 in a stepwise shape. Each of the plurality of second gate contacts 163 may be extended in the third direction Z to pass through the second interlayer insulating layer 144, and may be connected to the second gate electrodes 117 corresponding thereto in the extension area EA. In some example embodiments, a width of the second gate contact 163 may be reduced as the second gate contact 163 is directed toward the first interlayer insulating layer 142.

The first cell wiring structure 380 may be formed on the upper surface of the first stacked structure SS1. For example, a first inter-wiring insulating layer 340 covering the source structure 102 and the third interlayer insulating layer 104 may be formed, and the first cell wiring structure 380 may be formed in the first inter-wiring insulating layer 340. The first cell wiring structure 380 may be electrically connected to the source structure 102 and/or the first gate contact 162. The number and arrangement of the first cell wiring structures 380 are shown as being only an example, and are not limited thereto.

The second cell wiring structure 180 may be formed on a lower surface of the second stacked structure SS2. For example, a second inter-wiring insulating layer 146 covering the second interlayer insulating layer 144 may be formed, and the second cell wiring structure 180 may be formed in the second inter-wiring insulating layer 146. The second cell wiring structure 180 may be electrically connected to the channel structure CH and/or the second gate contact 163. The number and arrangement of the second cell wiring structures 180 shown in FIG. 4 are merely an example, and are not limited thereto.

In some example embodiments, the second cell wiring structure 180 may include a bit line BL. The bit line BL may be extended in the second direction Y and thus connected to the plurality of channel structures CH arranged along the second direction Y. For example, a bit line contact 161 may be formed in the second interlayer insulating layer 144. The bit line contact 161 may be connected to the other end of the channel layer 130. For example, as shown in FIG. 7, the bit line contact 161 may be in contact with a lower end of the second semiconductor layer 1302 and/or the second channel pad 137. The bit line BL may be electrically connected to the channel structure CH through the bit line contact 161. The plurality of bit lines BL may be spaced apart from each other and extended in parallel with each other in the second direction Y.

The first through vias 164 and 165 and the second through vias 166 and 167 may be disposed in the external area PA. The first through vias 164 and 165 and the second through vias 166 and 167 may be extended in the third direction Z and thus electrically connect the first cell wiring structure 380 with the second cell wiring structure 180.

In some embodiments, the first through vias 164 and 165 may be referred to as a first contact plug 164 and a second contact plug 165, respectively, and the second through vias 166 and 167 may be referred to as a third contact plug 166 and a fourth contact plug 167, respectively.

The first contact plug 164 and the third contact plug 166 may be disposed on sides of the first stacked structure SS1. For example, the first contact plug 164 and the third contact plug 166 may be extended in the third direction Z to pass through the third interlayer insulating layer 104 and the first interlayer insulating layer 142. In some example embodiments, widths of the first contact plug 164 and the third contact plug 166 may be respectively reduced as the first and third contact plugs 164 and 166 are directed toward the second interlayer insulating layer 144.

The second contact plug 165 and the fourth contact plug 167 may be disposed on sides of the second stacked structure SS2. The second contact plug 165 may be connected to the first contact plug 164, and the fourth contact plug 167 may be connected to the third contact plug 166. For example, the second contact plug 165 may be connected to the first contact plug 164 by passing through the second interlayer insulating layer 144, and the fourth contact plug 167 may be connected to the third contact plug 166 by passing through the second interlayer insulating layer 144. In some example embodiments, widths of the second contact plug 165 and the fourth contact plug 167 may be reduced as the second and fourth contact plugs 165 and 167 are directed toward the first interlayer insulating layer 142.

The conductive pad 390 may be disposed in the external area PA. The conductive pad 390 may be formed on the first cell wiring structure 380. For example, the conductive pad 390 may be formed in the first inter-wiring insulating layer 340. The conductive pad 390 may be electrically connected to the peripheral circuit structure PERI through the second through vias 166 and 167.

The peripheral circuit structure PERI may include a peripheral circuit substrate 200, a peripheral circuit element PT, and a peripheral circuit wiring structure 280.

The peripheral circuit substrate 200 may include, for example, a semiconductor substrate such as a silicon substrate, a germanium substrate, or a silicon-germanium substrate. In some example embodiments, the peripheral circuit substrate 200 may include a silicon-on-insulator (SOI) substrate or a germanium-on-insulator (GOI) substrate.

The peripheral circuit element PT may be formed on the peripheral circuit substrate 200. The peripheral circuit element PT may constitute the peripheral circuit (e.g., 30 of FIG. 1) that controls the operation of the semiconductor memory device. For example, the peripheral circuit element PT may include a control logic (e.g., 37 of FIG. 1), a row decoder (e.g., 33 of FIG. 1), and a page buffer (e.g., 35 of FIG. 1). In the following description, a surface of the peripheral circuit substrate 200 on which the peripheral circuit element PT is disposed may be referred to as a front side of the peripheral circuit substrate 200. On the contrary, a surface of the peripheral circuit substrate 200, which is opposite to the front side of the peripheral circuit substrate 200, may be referred to as a back side of the peripheral circuit substrate 200.

The peripheral circuit element PT may include, for example, a transistor, but is not limited thereto. For example, the peripheral circuit element PT may include various passive elements such as a capacitor, a resistor and an inductor as well as various active elements such as a transistor.

The peripheral circuit wiring structure 280 may be formed on the peripheral circuit element PT. For example, a third inter-wiring insulating layer 240 may be formed on the front side of the peripheral circuit substrate 200, and the peripheral circuit wiring structure 280 may be formed in the third inter-wiring insulating layer 240. The peripheral circuit wiring structure 280 may be electrically connected to the peripheral circuit element PT. The number and arrangement of the peripheral circuit wiring structures 280 shown in FIG. 3 are merely an example, and are not limited thereto.

In some example embodiments, the memory cell structure CELL may be stacked on the peripheral circuit structure PERI. For example, the memory cell structure CELL may be stacked on the third inter-wiring insulating layer 240.

In some example embodiments, the second stacked structure SS2 may be interposed between the peripheral circuit structure PERI and the first stacked structure SS1. For example, the lower surface of the second stacked structure SS2 may face the front side of the peripheral circuit substrate 200.

The semiconductor memory device according to some example embodiments may have a chip-to-chip (C2C) structure. The C2C structure means that an upper chip including the memory cell structure CELL is manufactured on a first wafer, a lower chip including the peripheral circuit structure PERI is manufactured on a second wafer different from the first wafer, and then the upper chip and the lower chip are connected to each other by a bonding method.

For example, the bonding method may mean a method for electrically connecting a first bonding metal 190 formed on the uppermost metal layer of the upper chip with a second bonding metal 290 formed on the uppermost metal layer of the lower chip. For example, when the first bonding metal 190 and the second bonding metal 290 are formed of copper (Cu), the bonding method may be a Cu-Cu bonding method. However, this is merely an example, and the first bonding metal 190 and the second bonding metal 290 may be formed of various other metals such as aluminum (Al) or tungsten (W).

As the first bonding metal 190 and the second bonding metal 290 are bonded to each other, the second cell wiring structure 180 may be electrically connected to the peripheral circuit wiring structure 280. Therefore, the source structure 102, the gate electrodes 112 and 117 and/or the bit line BL may be electrically connected to the peripheral circuit element PT.

As a semiconductor memory device including memory cells arranged three-dimensionally is highly integrated, an aspect ratio (AR) of a channel structure extended in a vertical direction is continuously increased. Therefore, there is a need for a high-quality channel structure to satisfy the required performance even while having a high aspect ratio.

The semiconductor memory device according to some example embodiments may have a structure in which the channel structure CH in the first stacked structure SS1 and the channel structure CH in the second stacked structure SS2 are bonded to each other as described above. That is, the channel structure CH in the first stacked structure SS1 and the channel structure CH in the second stacked structure SS2 may be formed in a separate step and bonded to each other. Therefore, the channel structure having an improved aspect ratio while mitigating or preventing quality from being deteriorated may be provided.

Also, in the semiconductor memory device according to some example embodiments, a channel layer 130 of the channel structure CH may have a structure in which the first semiconductor layer 1301 and the second semiconductor layer 1302, which are formed in different directions, are bonded to each other. For example, as described above, the first semiconductor layer 1301 may be formed based on an etching process performed in a direction (e.g., -Z direction) directed from the first stacked structure SS1 toward the second stacked structure SS2, and the second semiconductor layer 1302 may be formed based on an etching process performed in a direction (e.g., Z direction) from the second stacked structure SS2 toward the first stacked structure SS1. Therefore, both ends of the channel structure CH may be provided in a large area. For example, both the first channel pad 136 connected to the upper end of the first semiconductor layer 1301 and the second channel pad 137 connected to the lower end of the second semiconductor layer 1302 may be provided in a large area. As a result, the channel structure CH having improved connectivity with both the source structure 102 and the bit line BL may be provided.

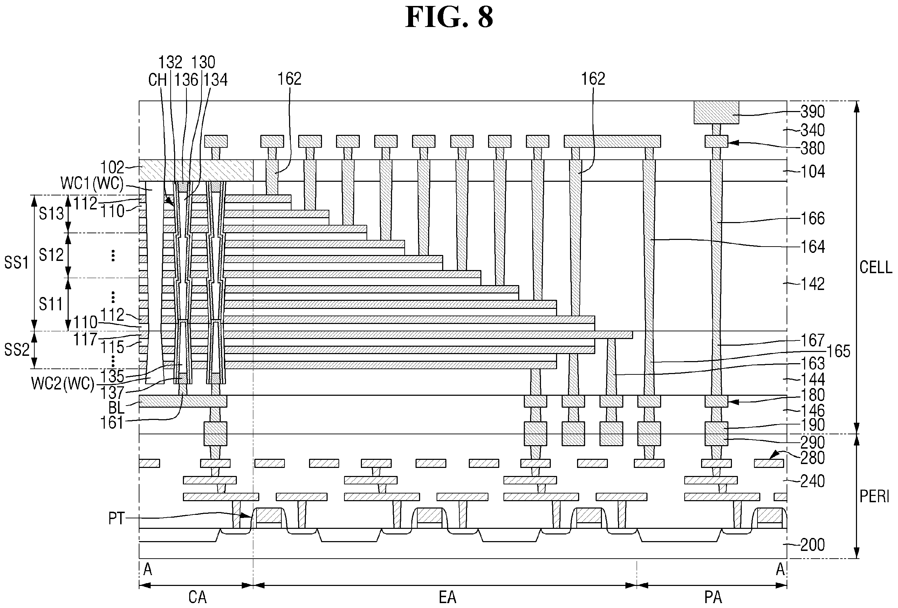

FIG. 8 is a cross-sectional view illustrating a semiconductor memory device according to an example embodiment. For convenience of description, redundant portions of those described above with reference to FIGS. 1 to 7 will be briefly described or omitted.

Referring to FIG. 8, in the semiconductor memory device according to an example embodiment, the cutting structure WC may include a first cutting pattern WC1 and a second cutting pattern WC2.

The first cutting pattern WC1 may be extended in the first direction X to cut the first stacked structure SS1. The second cutting pattern WC2 may be extended in the first direction X to cut the second stacked structure SS2. The first cutting pattern WC1 and the second cutting pattern WC2 may be connected to each other in the third direction Z.

The first cutting pattern WC1 may have a tapered shape toward the second stacked structure SS2. For example, a width of the first cutting pattern WC1 may be reduced as the first cutting pattern WC1 is directed toward the second stacked structure SS2. This may result from the fact that an etching process for forming the first cutting pattern WC1 is performed in a direction (e.g., Z direction) toward the second stacked structure SS2.

The second cutting pattern WC2 may have a tapered shape toward the first stacked structure SS1. For example, a width of the second cutting pattern WC2 may be reduced as the second cutting pattern WC2 is directed toward the first stacked structure SS1. This may result from the fact that an etching process for forming the second cutting pattern WC2 is performed in a direction (e.g., Z direction) toward the first stacked structure SS1.

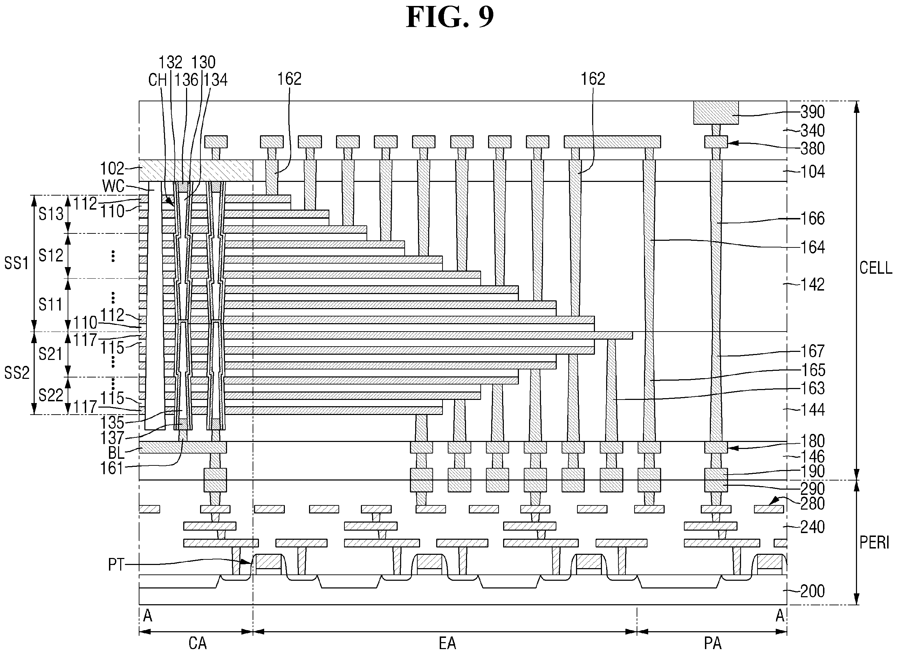

FIG. 9 is a cross-sectional view illustrating a semiconductor memory device according to some embodiments. For convenience of description, redundant portions of those described above with reference to FIGS. 1 to 7 will be briefly described or omitted.

Referring to FIG. 9, in the semiconductor memory device according to an example embodiment, the second stacked structure SS2 may include a plurality of stacks S21 and S22.

For example, the second stacked structure SS2 may include a fourth stack S21 and a fifth stack S22, which are sequentially stacked on the lower surface of the first stacked structure SS1. Each of the stacks S21 and S22 of the second stacked structure SS2 may include a plurality of second mold insulating layers 115 and a plurality of second gate electrodes 117 that are alternately stacked. Although only two stacks S21 and S22 stacked on the first stacked structure SS1 are shown, this is merely an example, and various modifications may be made in the number of the stacks S21 and S22.

In some example embodiments, the channel structure CH may have a tapered shape toward the first stacked structure SS1 in each of the stacks S21 and S22 of the second stacked structure SS2. For example, as shown, in each of the stacks S21 and S22 of the second stacked structure SS2, the width of the channel structure CH may be reduced as the channel structure CH is directed toward the first stacked structure SS1. This may result from the fact that an etching process for forming the channel structure CH with respect to the respective stacks S21 and S22 of the second stacked structure SS2 is performed in a direction (e.g., Z direction) toward the first stacked structure SS1.

In some example embodiments, the channel structure CH may have a step difference between the stacks S21 and S22 of the second stacked structure SS2. For example, on the boundary surface between the fourth stack S21 and the fifth stack S22, a width of a lower portion of the channel structure CH in the fourth stack S21 may be greater than a width of an upper portion of the channel structure CH in the fifth stack S22.

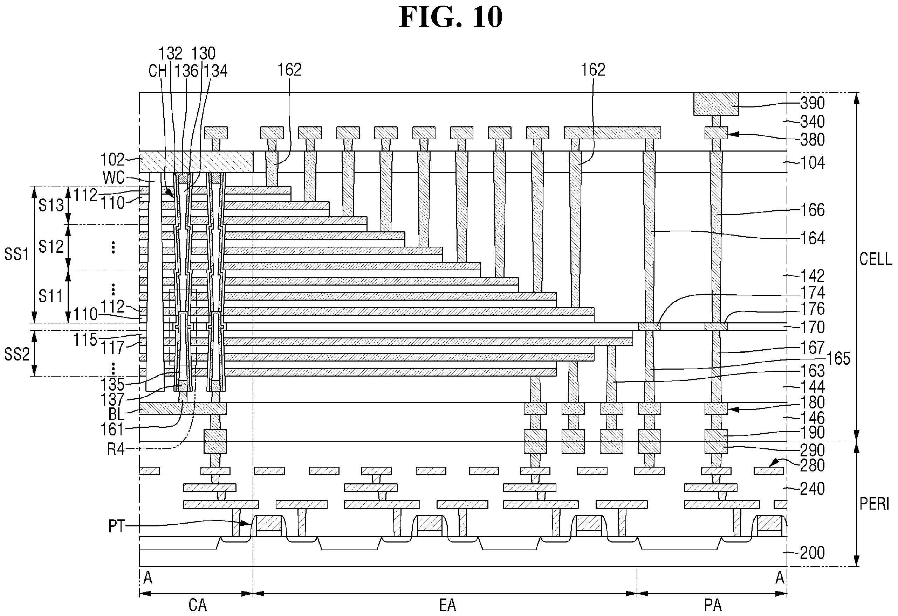

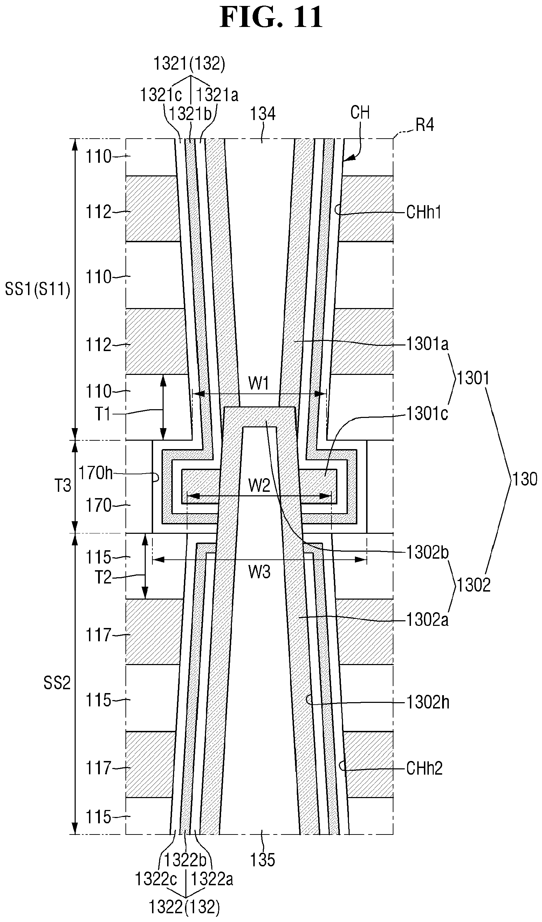

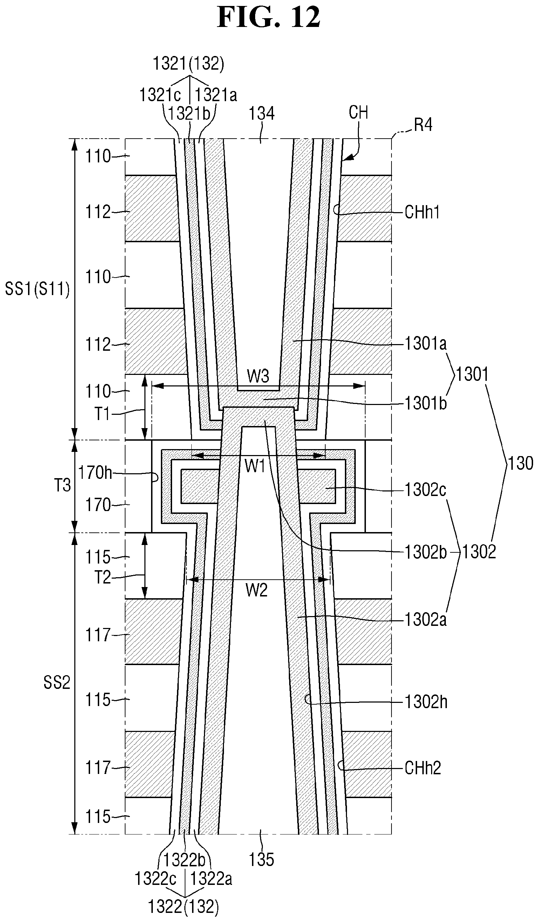

FIG. 10 is a cross-sectional view illustrating a semiconductor memory device according to an example embodiment. FIGS. 11 and 12 are various enlarged views illustrating a region R4 of FIG. 10. For convenience of description, redundant portions of those described above with reference to FIGS. 1 to 7 will be briefly described or omitted.

Referring to FIGS. 10 to 12, the semiconductor memory device according to an example embodiment may further include a pad insulating layer 170.

The pad insulating layer 170 may be interposed between the first stacked structure SS1 and the second stacked structure SS2. The pad insulating layer 170 may include at least one of, for example, silicon oxide, silicon oxynitride or a low-k material having a dielectric constant lower than that of the silicon oxide, but is not limited thereto.

The pad insulating layer 170 may include a pad hole 170h interposed between the first channel hole CHh1 and the second channel hole CHh2. The pad hole 170h may connect the first channel hole CHh1 with the second channel hole CHh2. The pad hole 170h may be wider than the first channel hole CHh1 and the second channel hole CHh2. For example, on a boundary surface between the first stacked structure SS1 and the pad insulating layer 170, a width W3 of the pad hole 170h may be greater than a width W1 of the first channel hole CHh1. For example, the width W3 of the pad hole 170h may be greater than a width W2 of the second channel hole CHh2 on a boundary surface the second stacked structure SS2 and the pad insulating layer 170.

The second semiconductor layer 1302 may be connected to the first semiconductor layer 1301 by passing through the second dielectric layer 1322 and the first dielectric layer 1321. For example, the connection hole 1302h may be extended in the third direction Z to pass through an upper portion of the second dielectric layer 1322 and a lower portion of the first dielectric layer 1321, and may expose a lower portion of the first semiconductor layer 1301. The second semiconductor layer 1302 may be formed in the connection hole 1302h and thus bonded to the first semiconductor layer 1301.

In some example embodiments, the first mold insulating layer 110 and the second mold insulating layer 115, which are adjacent to the pad insulating layer 170, may be formed to be thinner than the pad insulating layer 170. For example, a thickness T1 of the first mold insulating layer 110 adjacent to the pad insulating layer 170 and a thickness T2 of the second mold insulating layer 115 adjacent to the pad insulating layer 170 may be smaller than a thickness T3 of the pad insulating layer 170. In this case, a connection failure of the channel layer 130 due to a distance between the first gate electrodes 112 and the second gate electrodes 117 may be avoided.

In some example embodiments, a first contact pad 174 and a second contact pad 176 may be formed in the pad insulating layer 170. The first contact pad 174 may be interposed between the first contact plug 164 and the second contact plug 165, and the second contact pad 176 may be interposed between the third contact plug 166 and the fourth contact plug 167. The first contact pad 174 may connect the first contact plug 164 with the second contact plug 165, and the second contact pad 176 may connect the third contact plug 166 with the fourth contact plug 167. The first contact pad 174 may be wider than the first contact plug 164 and the second contact plug 165, and the second contact pad 176 may be wider than the third contact plug 166 and the fourth contact plug 167. The first contact pad 174 and the second contact pad 176 may mitigate or prevent a connection failure of the first through vias164 and 165 and the second through vias166 and 167 due to misalignment or the like from occurring.

Referring to FIGS. 10 and 11, in the semiconductor memory device according to an example embodiment, the first semiconductor layer 1301 may further include a first pad portion 1301c. The first pad portion 1301c may be formed in the pad hole 170h. The first pad portion 1301c may be extended along a plane (e.g., XY plane) crossing the third direction Z. For example, the lower portion of the first dielectric layer 1321 may be extended to be conformal along a profile of the pad hole 170h, and the first pad portion 1301c may fill at least a portion of an area of the pad hole 170h, which remains after the first dielectric layer 1321 is filled.

In some example embodiments, the second semiconductor layer 1302 may be connected to the first pad portion 1301c. A width of the first pad portion 1301c may be greater than a width of the second semiconductor layer 1302 at the plane crossing a vertical direction in the pad insulating layer 170. For example, the upper surface of the first horizontal portion 1302b may be protruded upward from a lowermost surface of the first pad portion 1301c. In some example embodiments, the second pillar portion 1302a may pass through the first pad portion 1301c. For example, the upper surface of the first horizontal portion 1302b may protrude upward from the upper surface of the first pad portion 1301c. The first pad portion 1301c may mitigate or prevent a connection failure of the channel layer 130 due to misalignment or the like from occurring. In some example embodiments, the width of the first pad portion 1301c is greater than a width of the first pillar portion 1301a.

Referring to FIGS. 10 and 12, in the semiconductor memory device according to an example embodiment, the second semiconductor layer 1302 may further include a second pad portion 1302c. The second pad portion 1302c may be formed in the pad hole 170h. The second pad portion 1302c may be extended along a plane (e.g., XY plane) crossing the third direction Z. For example, the upper portion of the second dielectric layer 1322 may be extended to be conformal along the profile of the pad hole 170h, and the second pad portion 1302c may fill at least a portion of an area of the pad hole 170h, which remains after the second dielectric layer 1322 is filled.

In some example embodiments, the first semiconductor layer 1301 may include a first pillar portion 1301a and a second horizontal portion 1301b. The second horizontal portion 1301b may be extended from a lower portion of the first pillar portion 1301a along a plane (e.g., XY plane) crossing the third direction Z. For example, the second horizontal portion 1301b may have a plate shape (for example, disk shape) for blocking the lower portion of the cylindrical first pillar portion 1301a. That is, the first semiconductor layer 1301 including the first pillar portion 1301a and the second horizontal portion 1301b may have a cup shape.

In some example embodiments, the second pillar portion 1302a may pass through the second pad portion 1302c. For example, the upper surface of the first horizontal portion 1302b may protrude upward from an upper surface of the second pad portion 1302c. In some example embodiments, the second semiconductor layer 1302 may be connected with the second horizontal portion 1301b. For example, the upper surface of the first horizontal portion 1302b may protrude upward from a lowermost surface of the second horizontal portion 1301b. The second pad portion 1302c may mitigate prevent a connection failure of the channel layer 130 due to misalignment or the like from occurring.

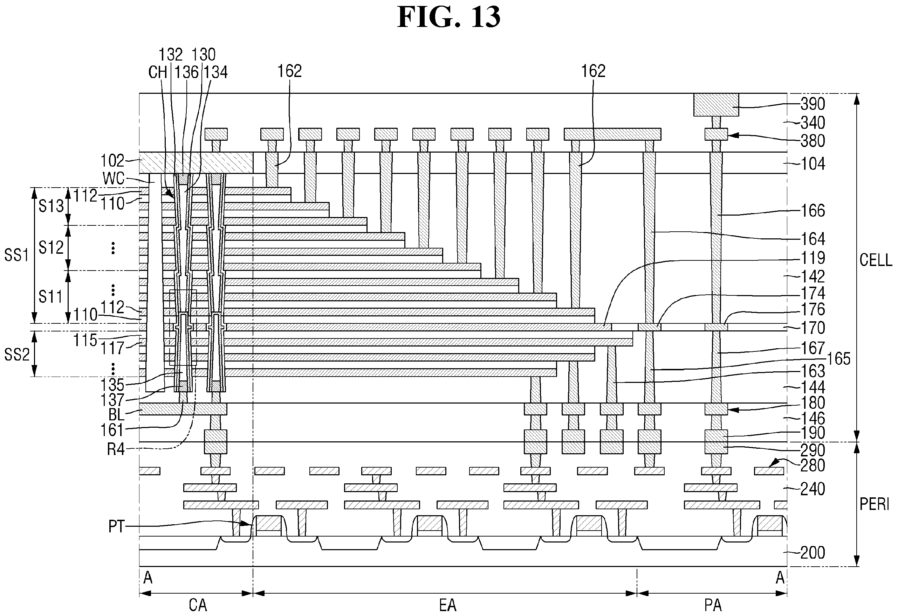

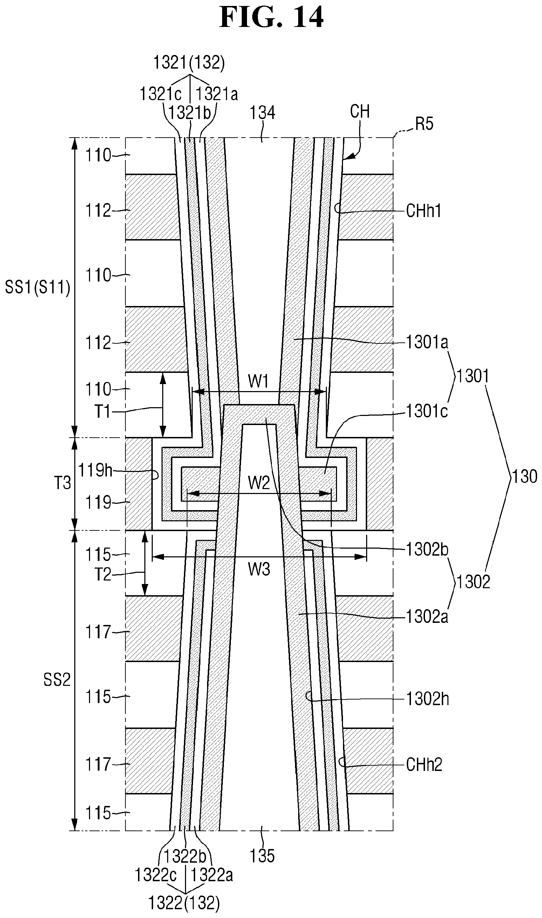

FIG. 13 is a cross-sectional view illustrating a semiconductor memory device according to some embodiments. FIGS. 14 to 17 are various enlarged views illustrating a region R4 of FIG. 13. For convenience of description, redundant portions of those described above with reference to FIGS. 1 to 12 will be briefly described or omitted.

Referring to FIGS. 13 to 17, the semiconductor memory device according to some embodiments may further include a dummy gate electrode 119.

The dummy gate electrode 119 may be formed in the pad insulating layer 170. The dummy gate electrode 119 may be spaced apart from the first gate electrodes 112 by the first mold insulating layer 110, and may be spaced apart from the second gate electrodes 117 by the second mold insulating layer 115. A portion of the channel layer 130 may cross the dummy gate electrode 119. The dummy gate electrode 119 may include a conductive material, for example, metal such as tungsten (W), molybdenum (Mo), ruthenium (Ru), cobalt (Co) or nickel (Ni) or a semiconductor material such as silicon, but is not limited thereto.

The dummy gate electrode 119 may include a pad hole 170h interposed between the first channel hole CHh1and the second channel hole CHh2. Because the pad hole 170h is similar to that described above with reference to FIGS. 10 to 12, its detailed description will be omitted.

Referring to FIGS. 13 and 14, in the semiconductor memory device according to an example embodiment, the first semiconductor layer 1301 may further include a first pad portion 1301c. Because the first pad portion 1301c is similar to that described above with reference to FIGS. 10 and 11, its detailed description will be omitted.

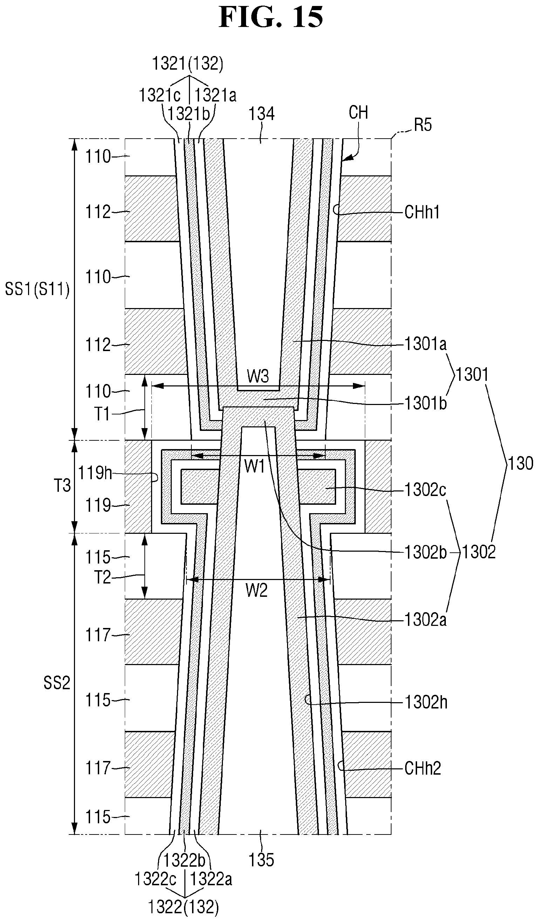

Referring to FIGS. 13 and 15, in the semiconductor memory device according to an example embodiment, the second semiconductor layer 1302 may further include a second pad portion 1302c. Because the second pad portion 1302c is similar to that described above with reference to FIGS. 10 and 12, its detailed description will be omitted.

Referring to FIGS. 13, 16 and 17, in the semiconductor memory device according to some example embodiments, the dummy gate electrode 119 may include a plurality of dummy word lines 1191 to 1193 spaced apart from one another and sequentially stacked.

For example, the dummy word lines 1191 to 1193 may be sequentially stacked by being spaced apart from one another by first mold insulating layers 110. The number and shape of the dummy word lines 1191 to 1193 are not limited to those shown.

In some example embodiments, the pad hole 170h may connect the first channel hole CHh1 with the second channel hole CHh2 by passing through the dummy word lines 1191 to 1193.

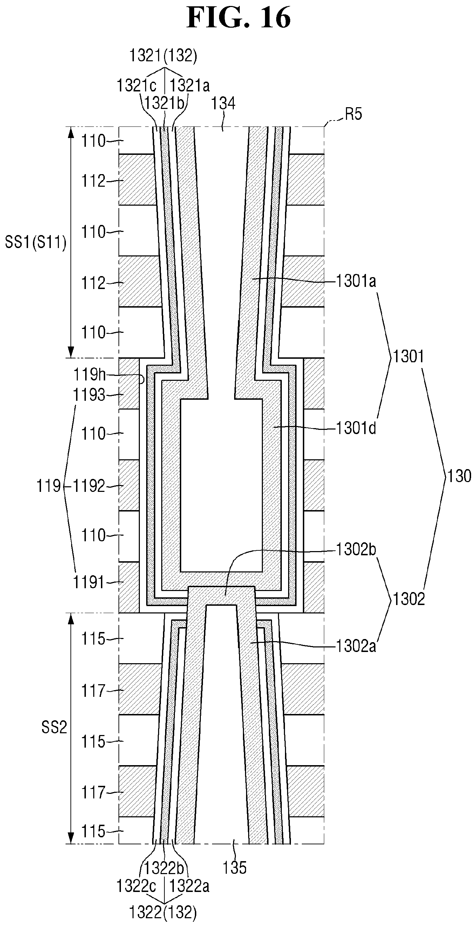

In some example embodiments, as shown in FIG. 16, the first semiconductor layer 1301 may include a first extension portion 1301d in the dummy word lines 1191 to 1193. The first extension portion 1301d may be formed in the pad hole 170h. For example, the lower portion of the first dielectric layer 1321 may be extended to be conformal along the profile of the pad hole 170h, and the first extension 1301d may be extended to be conformal along a profile of the first dielectric layer 1321 in the pad hole 170h.

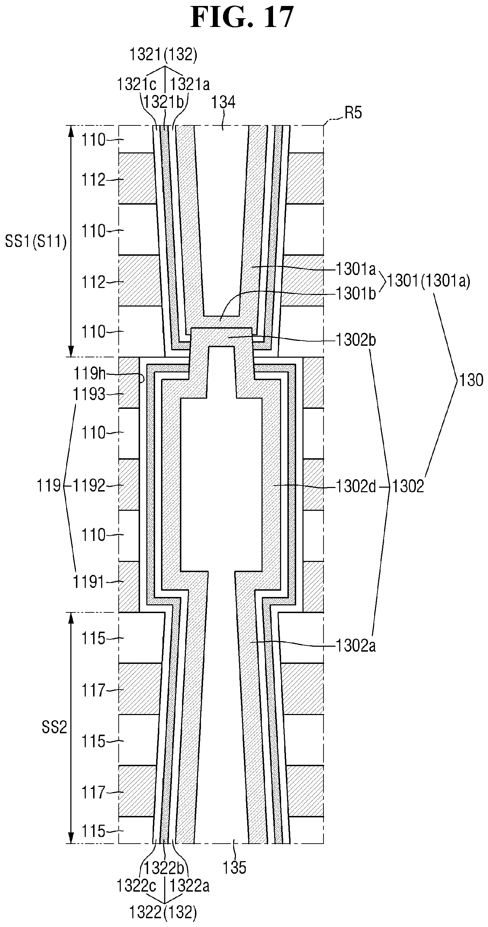

In some example embodiments, as shown in FIG. 17, the second semiconductor layer 1302 may further include a second extension 1302d in the dummy word lines 1191 to 1193. The second extension portion 1302d may be formed in the pad hole 170h. For example, the upper portion of the second dielectric layer 1322 may be extended to be conformal along the profile of the pad hole 170h, and the second extension portion 1302d may be extended to be conformal along a profile of the second dielectric layer 1322 in the pad hole 170h.

Hereinafter, a method for fabricating a semiconductor memory device according to some example embodiments will be described below with reference to FIGS. 1 to 57.

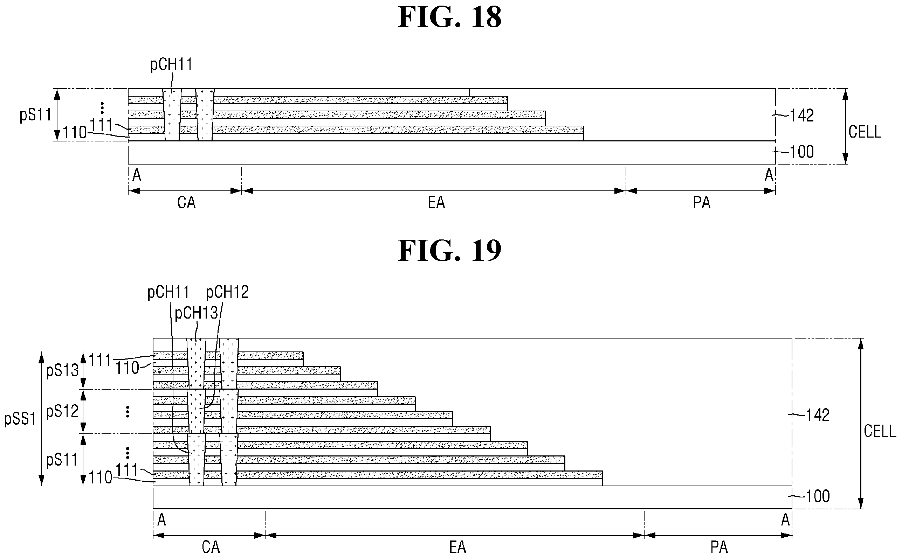

FIGS. 18 to 34 are views illustrating intermediate steps to describe a method for fabricating a semiconductor memory device according to an example embodiment. For convenience of description, redundant portions of those described above with reference to FIGS. 1 to 17 will be briefly described or omitted.

Referring to FIG. 18, a first mold pS11, a first interlayer insulating layer 142, and a first preliminary channel pCH11 are formed on a base substrate 100.

The base substrate 100 may include, for example, a semiconductor substrate such as a silicon substrate, a germanium substrate or a silicon-germanium substrate. In some example embodiments, the base substrate 100 may include a silicon-on-insulator (SOI) substrate or a germanium-on-insulator (GOI) substrate.

The first mold pS11 may include a plurality of first mold insulating layers 110 and a plurality of first mold sacrificial layers 111 that are alternately stacked. The first mold sacrificial layers 111 may include a material having an etch selectivity with respect to the first mold insulating layers 110. For example, the first mold insulating layers 110 may include a silicon oxide layer, and the first mold sacrificial layers 111 may include a silicon nitride layer. The first mold pS11 in the extension area EA may be patterned in a stepwise shape. Therefore, the first mold sacrificial layers 111 of the first mold pS11 may be stacked in a stepwise shape. The first interlayer insulating layer 142 may be formed to cover the first mold pS11.

The first preliminary channel pCH11 may pass through the first mold pS11 in the cell array area CA. The first preliminary channel pCH11 may include a material having an etch selectivity with respect to the first mold insulating layers 110 and the first mold sacrificial layers 111. For example, the first preliminary channel pCH11 may include polysilicon (poly-Si).

Referring to FIG. 19, a second mold pS12, a second preliminary channel pCH12, a third mold pS13 and a third preliminary channel pCH13 are formed on the first mold pS11 and the first preliminary channel pCH11.

The second mold pS12and the third mold pS13 may include a plurality of first mold insulating layers 110 and a plurality of first mold sacrificial layers 111 that are alternately stacked. The formation of the second mold pS12 and the third mold pS13 may be similar to the formation of the first mold pS11, and thus a detailed description thereof will be omitted. Therefore, a first preliminary stacked structure pSS 1 including the first mold pS11, the second mold pS12 and the third mold pS13 may be formed.

The second preliminary channel pCH12 may pass through the second mold pS12 in the cell array area CA, and the third preliminary channel pCH13 may pass through the third mold pS13 in the cell array area CA. In addition, the second preliminary channel pCH12 may be connected to the first preliminary channel pCH11, and the third preliminary channel pCH13 may be connected to the second preliminary channel pCH12. The formation of the second preliminary channel pCH12 and the third preliminary channel pCH13 may be similar to the formation of the first preliminary channel pCH11, and thus a detailed description thereof will be omitted.

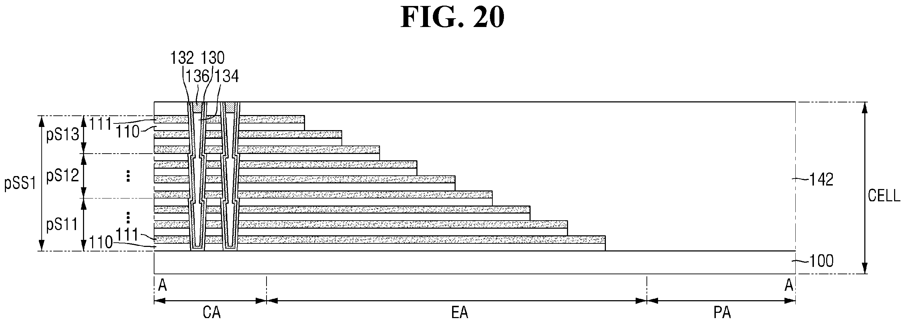

Referring to FIG. 20, a channel layer 130, a data storage layer 132, a first filling insulating layer 134 and a first channel pad 136 are formed in the first preliminary stacked structure pSS1.

For example, the first preliminary channel pCH11, the second preliminary channel pCH12 and the third preliminary channel pCH13 in the first preliminary stacked structure pSS1 may be selectively removed. Subsequently, the data storage layer 132, the channel layer 130, the first filling insulating layer 134 and the first channel pad 136 may be sequentially formed in an area from which the first preliminary channel pCH11, the second preliminary channel pCH12 and the third preliminary channel pCH13 are removed.

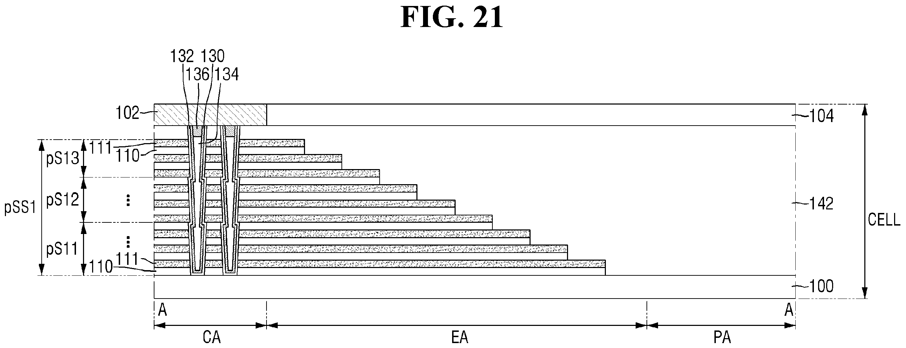

Referring to FIG. 21, a source structure 102 and a third interlayer insulating layer 104 are formed on the first interlayer insulating layer 142.

The source structure 102 may be formed on the first interlayer insulating layer 142 of the cell array area CA. The source structure 102 may be in contact with one end of the channel layer 130 and/or the first channel pad 136. The third interlayer insulating layer 104 may be formed on the first interlayer insulating layer 142 of the extension area EA and the external area PA.

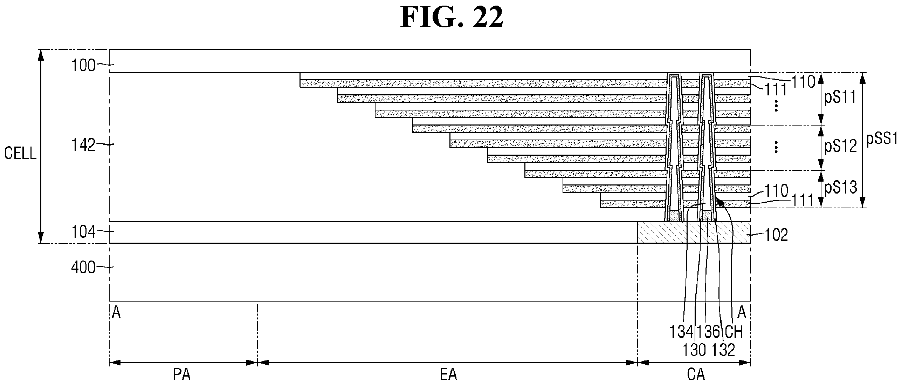

Referring to FIG. 22, a memory cell structure CELL is attached onto a carrier substrate 400.

For example, the carrier substrate 400 may be attached onto the source structure 102 and the third interlayer insulating layer 104. The memory cell structure CELL to which the carrier substrate 400 is attached may be inverted.

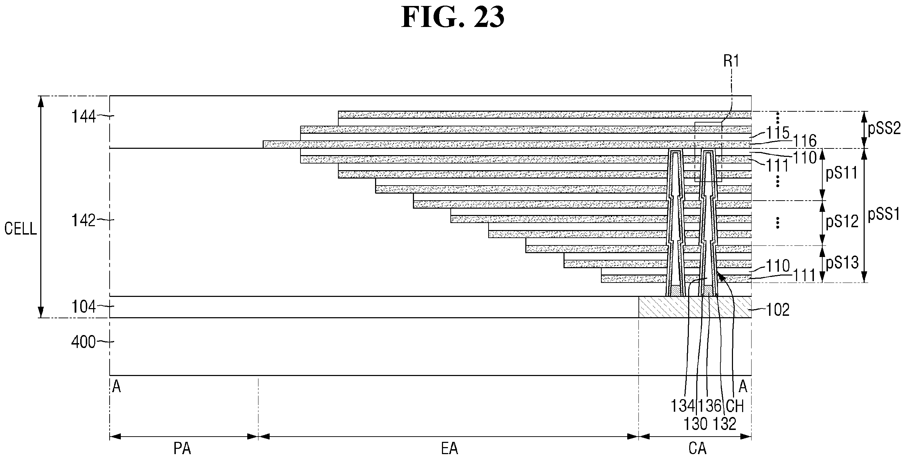

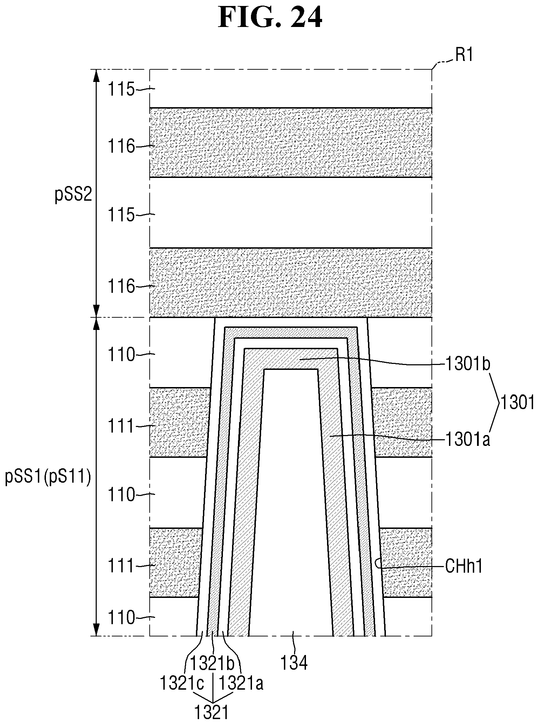

Referring to FIG. 23 and FIG. 24, a second preliminary stacked structure pSS2 and a second interlayer insulating layer 144 are formed on the first preliminary stacked structure pSS 1 and the first interlayer insulating layer 142. For reference, FIG. 24 is an enlarged view illustrating a region R1 of FIG. 23.

For example, the base substrate 100 may be removed. Then, the second preliminary stacked structure pSS2 may be formed on an upper surface of the first preliminary stacked structure pSS1 and an upper surface of the first interlayer insulating layer 142. The second preliminary stacked structure pSS2 may include a plurality of second mold insulating layers 115 and a plurality of second mold sacrificial layers 116 that are alternately stacked. The second mold sacrificial layers 116 may include a material having an etch selectivity with respect to the second mold insulating layers 115. For example, the second mold insulating layers 115 may include a silicon oxide layer, and the second mold sacrificial layers 116 may include a silicon nitride layer. The second preliminary stacked structure pSS2 in the extension area EA may be patterned in a stepwise shape. Therefore, the second mold sacrificial layers 116 of the second preliminary stacked structure pSS2 may be stacked in a stepwise shape. The second interlayer insulating layer 144 may be formed to cover the second preliminary stacked structure pSS2.

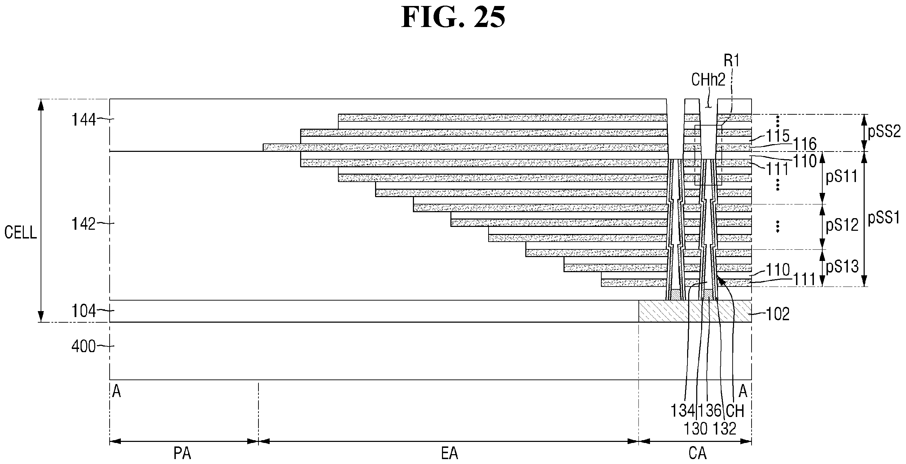

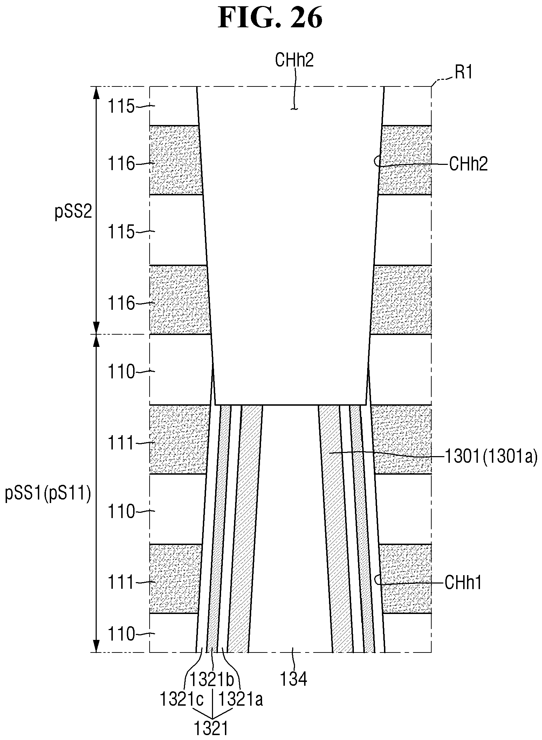

Referring to FIGS. 25 and 26, a second channel hole CHh2 is formed in the second preliminary stacked structure pSS2. For reference, FIG. 26 is an enlarged view illustrating a region R1 of FIG. 25.

The second channel hole CHh2 may pass through the second preliminary stacked structure pSS2. For example, a lower surface of the second channel hole CHh2 may be formed to be lower than a boundary surface between the first preliminary stacked structure pSS1 and the second preliminary stacked structure pSS2. Although the second horizontal portion 1301b of the first semiconductor layer 1301 is shown as being completely removed by the second channel hole CHh2, this is merely an example, and at least a portion of the second horizontal portion 1301b may remain after the second channel hole CHh2 is formed.

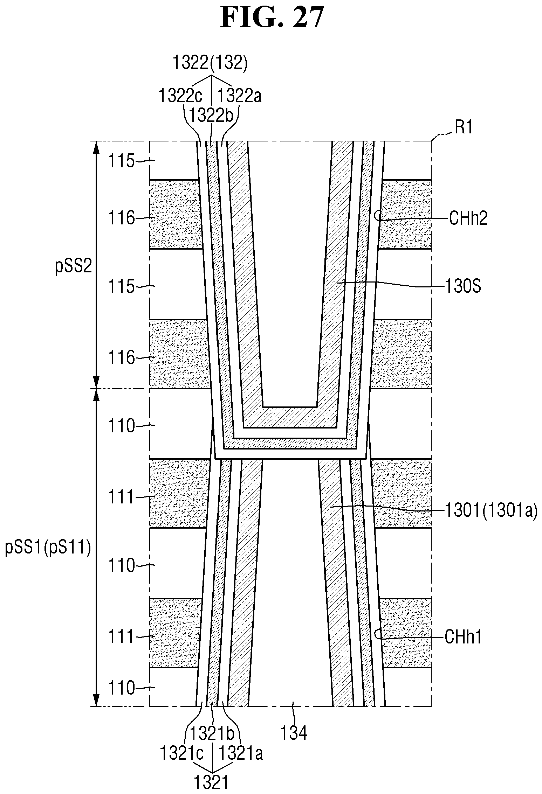

Referring to FIG. 27, a second dielectric layer 1322 and a sacrificial semiconductor layer 130S are sequentially formed in the second channel hole CHh2.

The sacrificial semiconductor layer 130S may be extended to be conformal along a profile of the second dielectric layer 1322. The sacrificial semiconductor layer 130S may include, for example, a semiconductor material such as monocrystalline silicon, polycrystalline silicon (polysilicon), an organic semiconductor material, or a carbon nanostructure, but is not limited thereto.

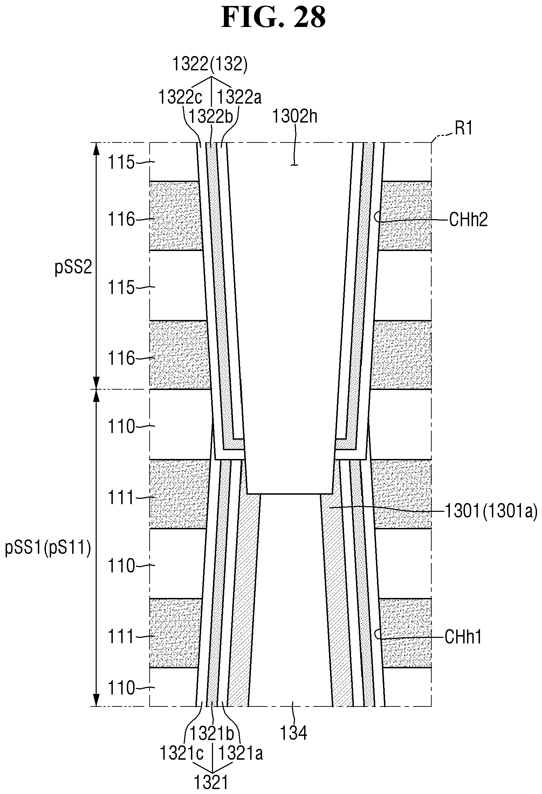

Referring to FIG. 28, a connection hole 1302h exposing the first semiconductor layer 1301 is formed in the second channel hole CHh2.

The connection hole 1302h may expose the upper portion of the first semiconductor layer 1301 by passing through the lower portion of the second dielectric layer 1322. For example, the connection hole 1302h may expose the first pillar portion 1301a. The sacrificial semiconductor layer 130S may be provided as a protective layer for protecting the second dielectric layer 1322 in a process of forming the connection hole 1302h.

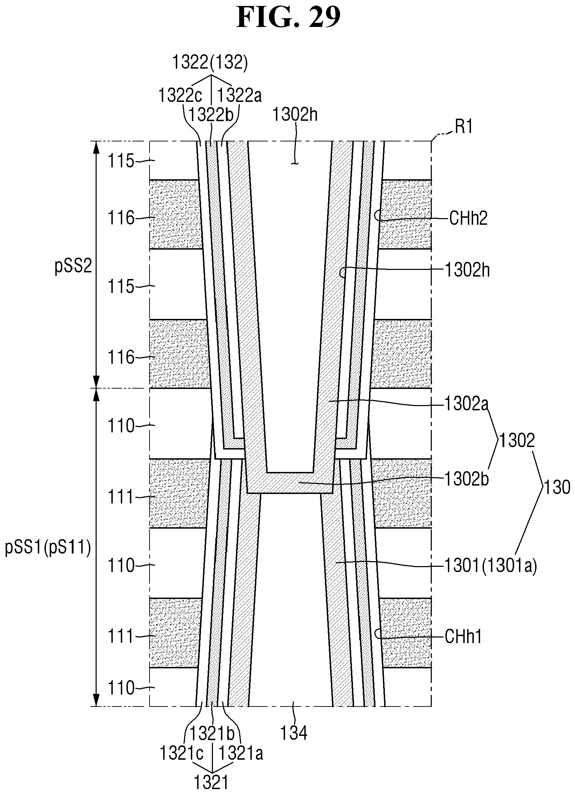

Referring to FIG. 29, a second semiconductor layer 1302 is formed in the connection hole 1302h.

Therefore, the second semiconductor layer 1302 bonded to the first semiconductor layer 1301 may be formed. In some example embodiments, the second semiconductor layer 1302 may be extended to be conformal along a profile of the connection hole 1302h. Therefore, the second semiconductor layer 1302 including a second pillar portion 1302a and a first horizontal portion 1302b may be formed. In addition, the channel layer 130 including the first semiconductor layer 1301 and the second semiconductor layer 1302 may be formed.

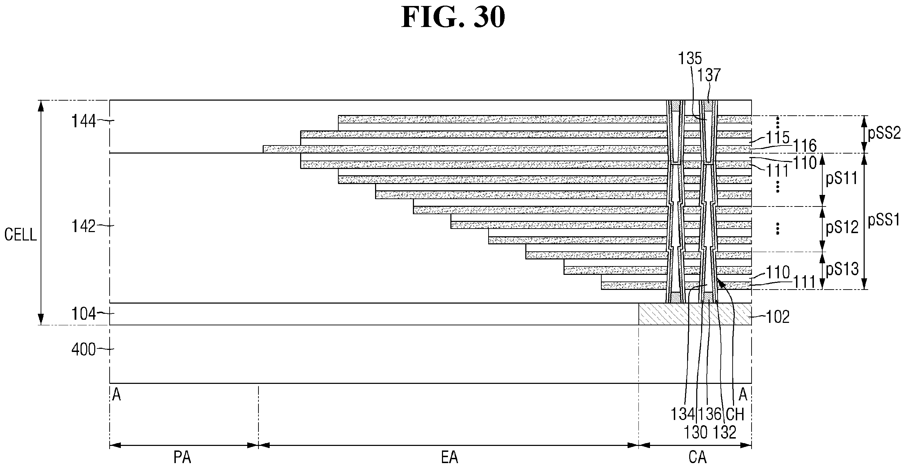

Referring to FIG. 30, a second filling insulating layer 135 and a second channel pad 137 are sequentially formed on the channel layer 130. A channel structure CH including the channel layer 130, the data storage layer 132, the first filling insulating layer 134, the second filling insulating layer 135, the first channel pad 136 and the second channel pad 137 may be formed.

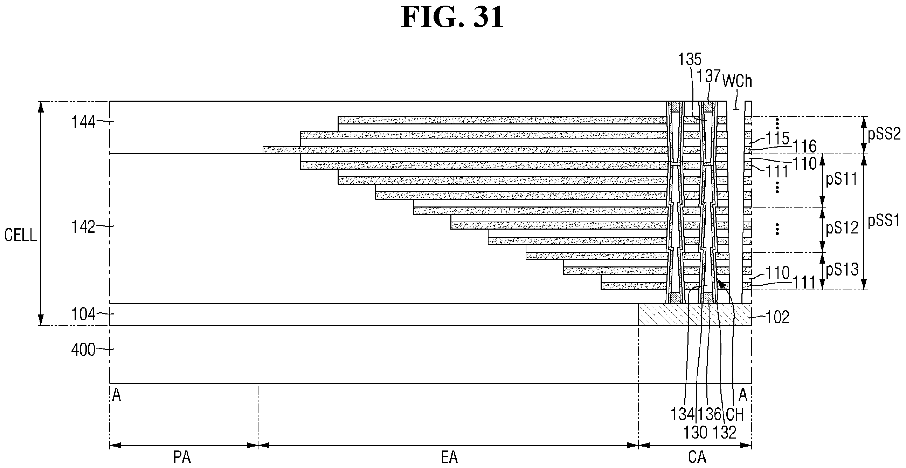

Referring to FIG. 31, a cutting area WCh for cutting the first preliminary stacked structure pSS1 and the second preliminary stacked structure pSS2 is formed.

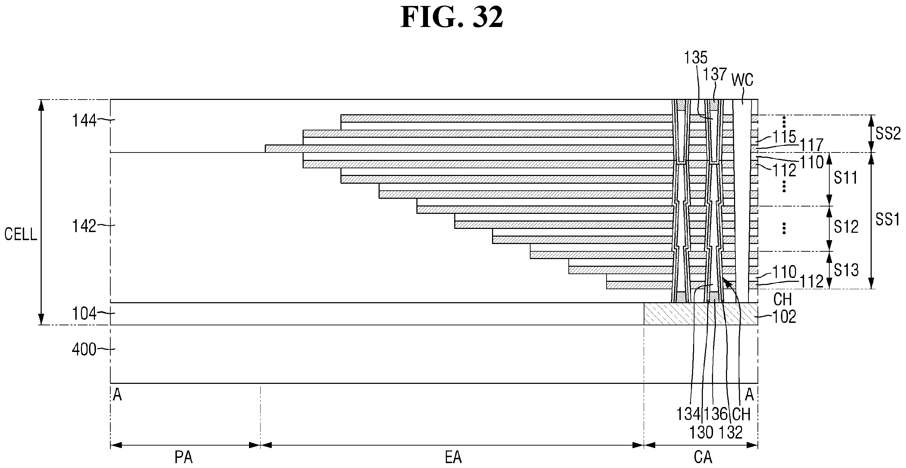

Referring to FIG. 32, a plurality of gate electrodes 112 and 117 are formed.

For example, the mold sacrificial layers 111 and 116 exposed by the cutting area WCh may be selectively removed. Then, gate electrodes 112 and 117, which replace the area from which the mold sacrificial layers 111 and 116 are removed, may be formed. Therefore, the first stacked structure SS1 including a plurality of first gate electrodes 112 and the second stacked structure SS2 including a plurality of second gate electrodes 117 may be formed. After the plurality of gate electrodes 112 and 117 are formed, a cutting structure WC filling the cutting area WCh may be formed.

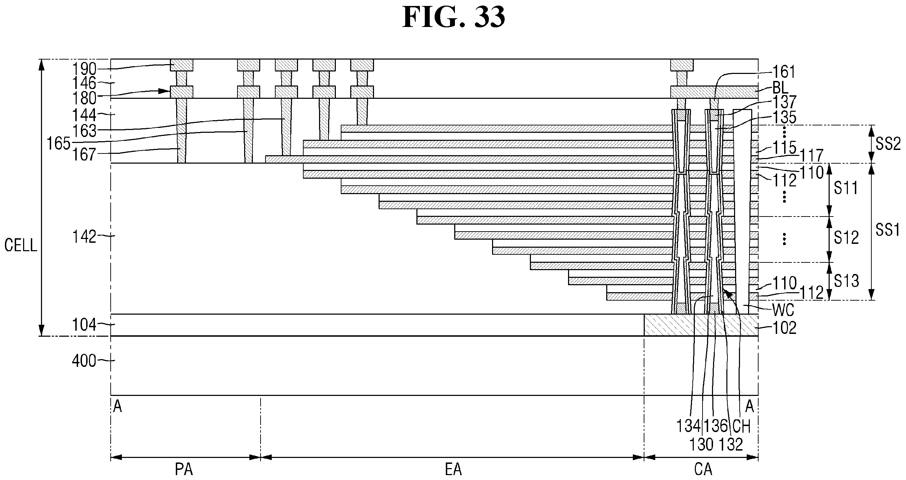

Referring to FIG. 33, a second inter-wiring insulating layer 146, a second cell wiring structure 180 and a first bonding metal 190 are formed on the second interlayer insulating layer 144.

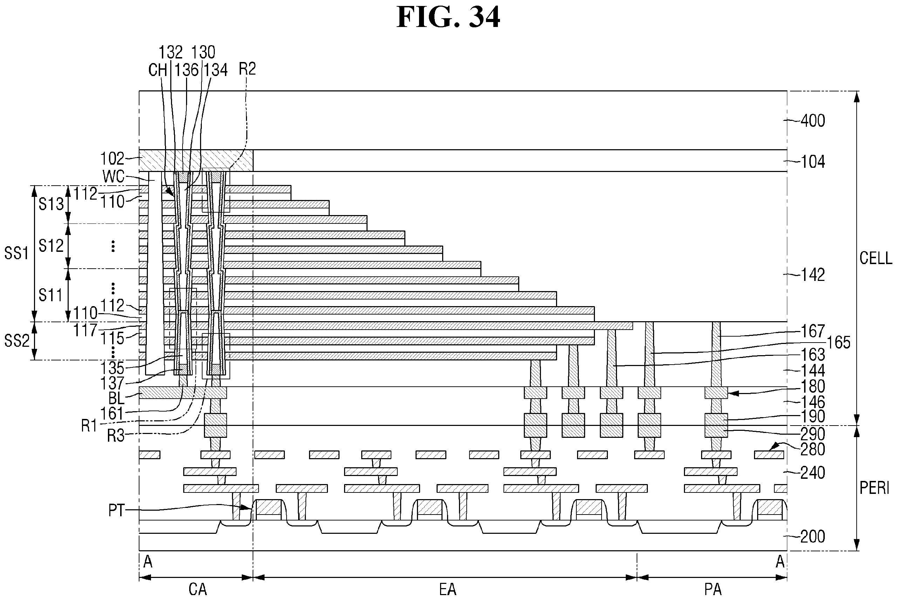

Referring to FIG. 34, the memory cell structure CELL is stacked on the peripheral circuit structure PERI.

For example, a first bonding metal 190 of the memory cell structure CELL may be bonded with a second bonding metal 290 of a peripheral circuit structure PERI. For example, when the first bonding metal 190 and the second bonding metal 290 are formed of copper (Cu), the bonding method may be a Cu-Cu bonding method.

Next, referring to FIG. 4, a first inter-wiring insulating layer 340, a first cell wiring structure 380 and a conductive pad 390 are formed on the source structure 102 and the third interlayer insulating layer 104. Therefore, the semiconductor memory device described with FIGS. 3 to 7 may be fabricated.

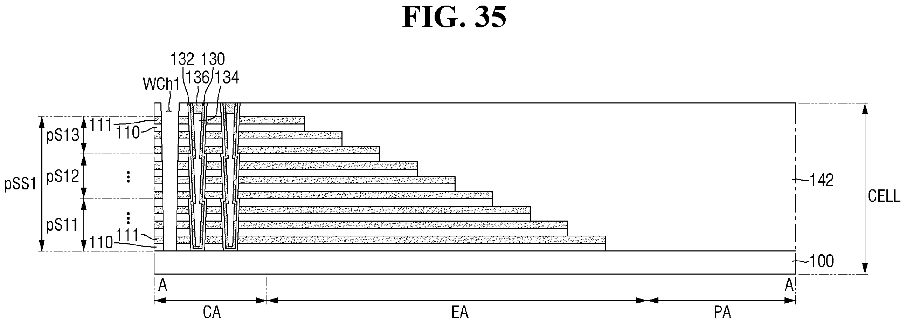

FIGS. 35 to 39 are views illustrating intermediate steps to describe a method for fabricating a semiconductor memory device according to an example embodiment. For convenience of description, redundant portions of those described above with reference to FIGS. 1 to 34 will be briefly described or omitted. For reference, FIG. 35 is a view illustrating an intermediate step to describe steps subsequent to FIG. 20.

Referring to FIG. 35, a first cutting area WCh1 for cutting the first preliminary stacked structure pSS1 is formed.

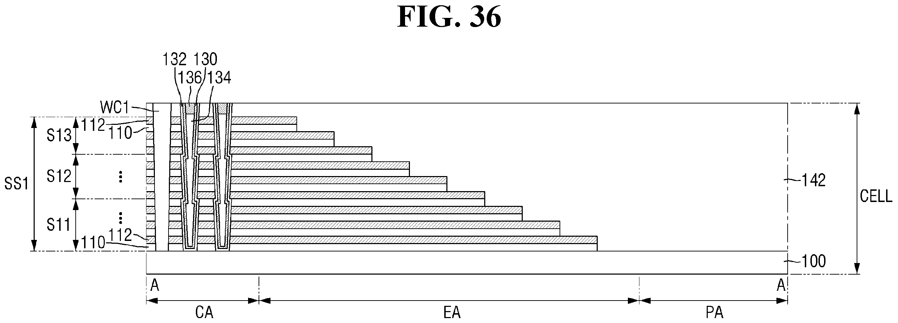

Referring to FIG. 36, a plurality of first gate electrodes 112 are formed.

For example, the first mold sacrificial layers 111 exposed by the first cutting area WCh1 may be selectively removed. Then, first gate electrodes 112, which replace the area from which the first mold sacrificial layers 111 are removed, may be formed. Therefore, the first stacked structure SS1 including the plurality of first gate electrodes 112 may be formed. After the plurality of first gate electrodes 112 are formed, a first cutting pattern WC1 for filling the first cutting area WCh1 may be formed.

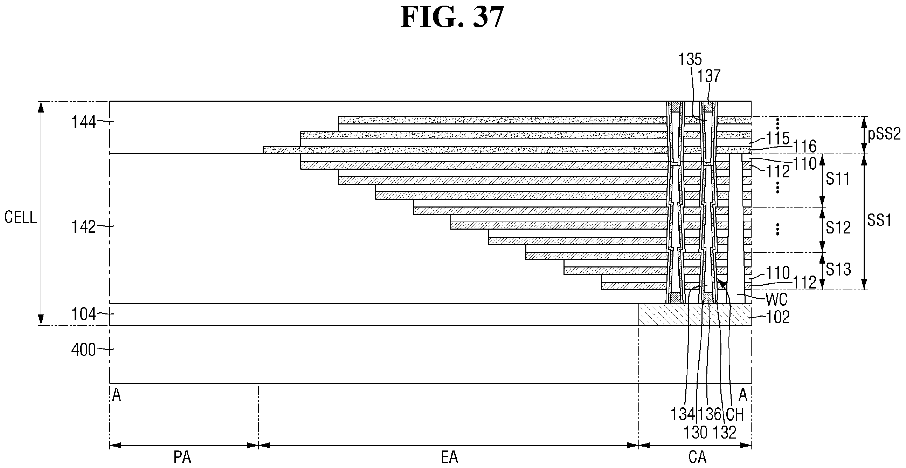

Referring to FIG. 37, a source structure 102, a third interlayer insulating layer 104, a second preliminary stacked structure pSS2 and a channel structure CH are formed. For example, the steps described with reference to FIGS. 21 to 30 may be performed.

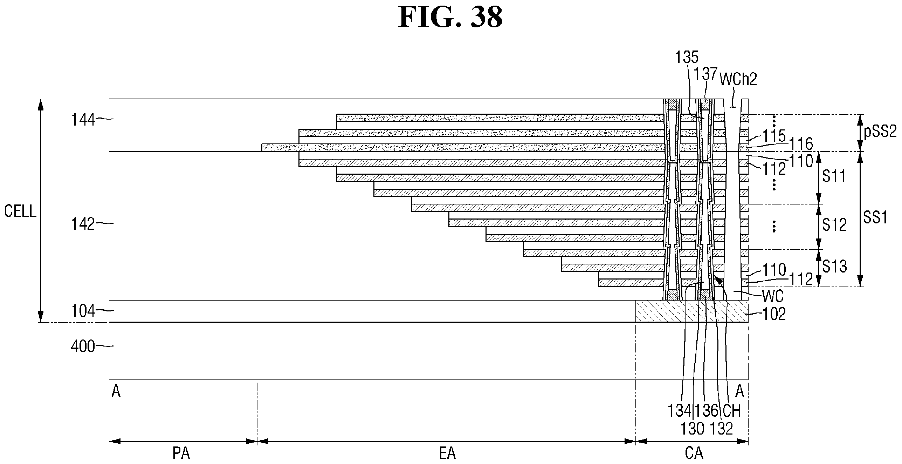

Referring to FIG. 38, a second cutting area WCh2 for cutting the second preliminary stacked structure pSS2 is formed.

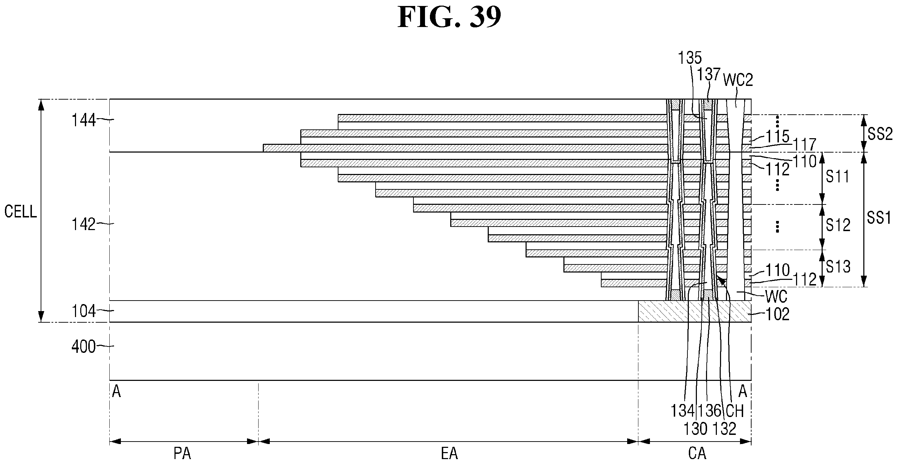

Referring to FIG. 39, a plurality of second gate electrodes 117 are formed.

For example, the second mold sacrificial layers 116 exposed by the second cutting area WCh2 may be selectively removed. Then, second gate electrodes 117, which replace the area from which the second mold sacrificial layers 116 are removed, may be formed. Therefore, the second stacked structure SS2 including a plurality of second gate electrodes 117 may be formed. After the plurality of second gate electrodes 117 are formed, the second cutting pattern WC2 for filling the second cutting area WCh2 may be formed.

Subsequently, the steps described with reference to FIGS. 33, 34 and 4 may be performed. Therefore, the semiconductor memory device described with reference to FIG. 8 may be fabricated.

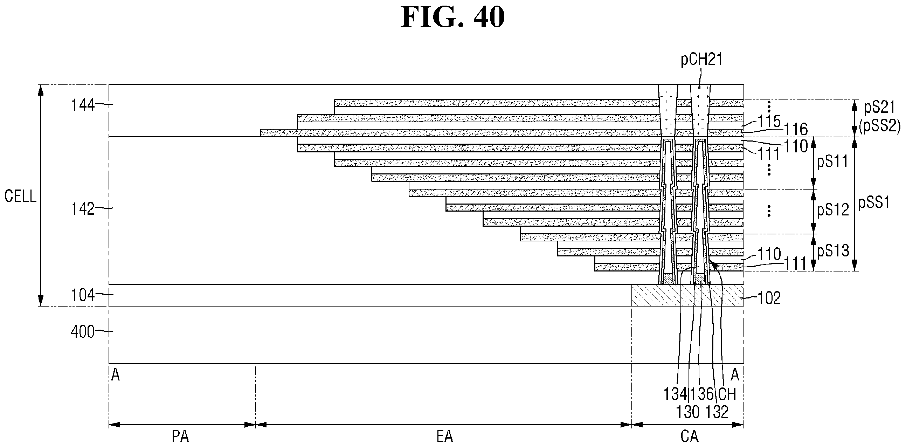

FIGS. 40 to 42 are views illustrating intermediate steps to describe a method for fabricating a semiconductor memory device according to an example embodiment. For convenience of description, redundant portions of those described above with reference to FIGS. 1 to 34 will be briefly described or omitted. For reference, FIG. 40 is a view illustrating an intermediate step to describe steps subsequent to FIG. 23.

Referring to FIG. 40, a fourth mold pS21, a second interlayer insulating layer 144 and a fourth preliminary channel pCH21 are formed on the first preliminary stacked structure pSS1.

The fourth mold pS21 may include a plurality of second mold insulating layers 115 and a plurality of second mold sacrificial layers 116 that are alternately stacked. The fourth mold pS21 in the extension area EA may be patterned in a stepwise shape. The second interlayer insulating layer 144 may be formed to cover the fourth mold pS21.

The fourth preliminary channel pCH21 may pass through the fourth mold pS21 in the cell array area CA. The fourth preliminary channel pCH21 may include a material having an etch selectivity with respect to the second mold insulating layers 115 and the second mold sacrificial layers 116. For example, the fourth preliminary channel pCH21 may include polysilicon (poly-Si).

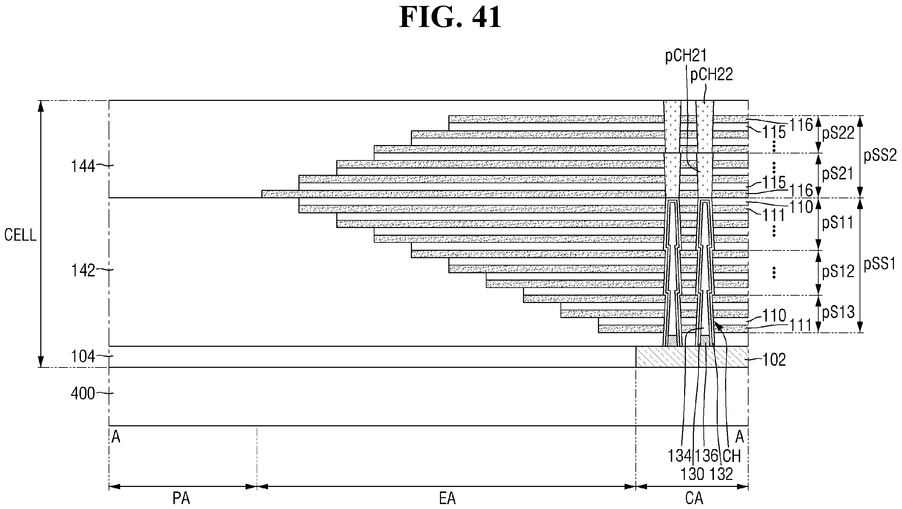

Referring to FIG. 41, a fifth mold pS22 and a fifth preliminary channel pCH22 are formed on the fourth mold pS21 and the fourth preliminary channel pCH21.

The fifth mold pS22 may include a plurality of second mold insulating layers 115 and a plurality of second mold sacrificial layers 116 that are alternately stacked. The formation of the fifth mold pS22 may be similar to the formation of the fourth mold pS21, and thus a detailed description thereof will be omitted. Therefore, the second preliminary stacked structure pSS2 including the fourth mold pS21 and the fifth mold pS22 may be formed.

The fifth preliminary channel pCH22 may pass through the fifth mold pS22 in the cell array area CA. In addition, the fifth preliminary channel pCH22 may be connected to the fourth preliminary channel pCH21. The formation of the fifth preliminary channel pCH22 may be similar to the formation of the fourth preliminary channel pCH21, and thus a detailed description thereof will be omitted.

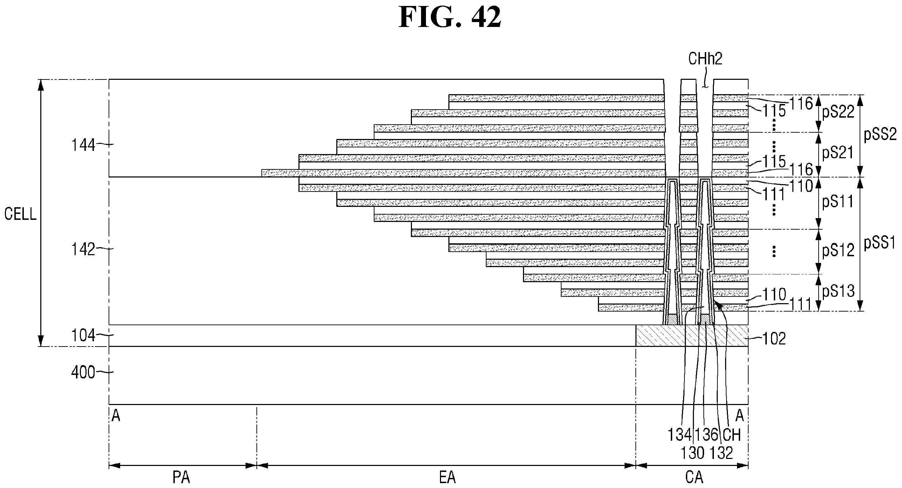

Referring to FIG. 42, the fourth preliminary channel pCH21 and the fifth preliminary channel pCH22 are selectively removed. Therefore, the second channel hole CHh2 passing through the second preliminary stacked structure pSS2 may be formed.

Subsequently, the steps described with reference to FIGS. 27 to 34 and 4 may be performed. Therefore, the semiconductor memory device described with reference to FIG. 9 may be fabricated.

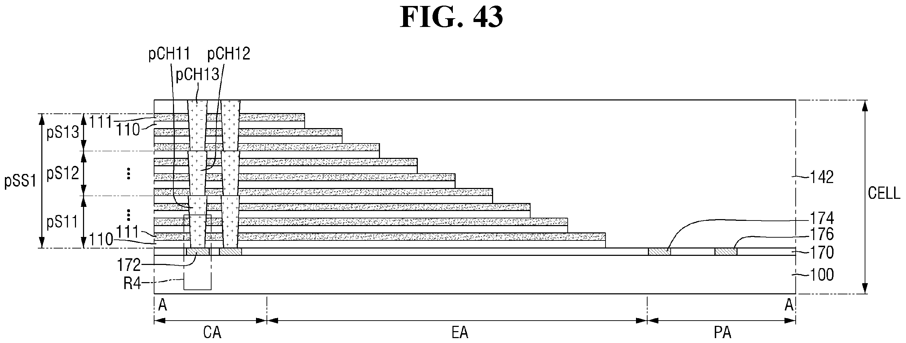

FIGS. 43 to 51 are views illustrating intermediate steps to describe a method for fabricating a semiconductor memory device according to an example embodiment. For convenience of description, redundant portions of those described above with reference to FIGS. 1 to 34 will be briefly described or omitted.

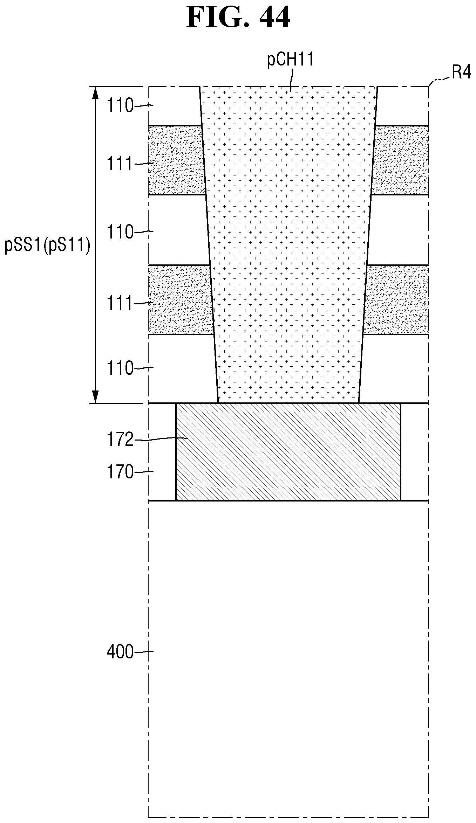

Referring to FIGS. 43 and 44, a pad insulating layer 170, a sacrificial pad 172, a first preliminary stacked structure pSS1, a first interlayer insulating layer 142, a first preliminary channel pCH11, a second preliminary channel pCH12 and a third preliminary channel pCH13 are formed on a base substrate 100. For reference, FIG. 44 is an enlarged view illustrating a region R4 of FIG. 43.

The pad insulating layer 170 may be formed on the base substrate 100. The sacrificial pad 172 may be formed in the pad insulating layer 170 of the cell array area CA. In some example embodiments, a first contact pad 174 and a second contact pad 176 may be further formed in the pad insulating layer 170 of the external area PA.

The first preliminary stacked structure pSS1, the first interlayer insulating layer 142, the first preliminary channel pCH11, the second preliminary channel pCH12 and the third preliminary channel pCH13 may be formed on the pad insulating layer 170.

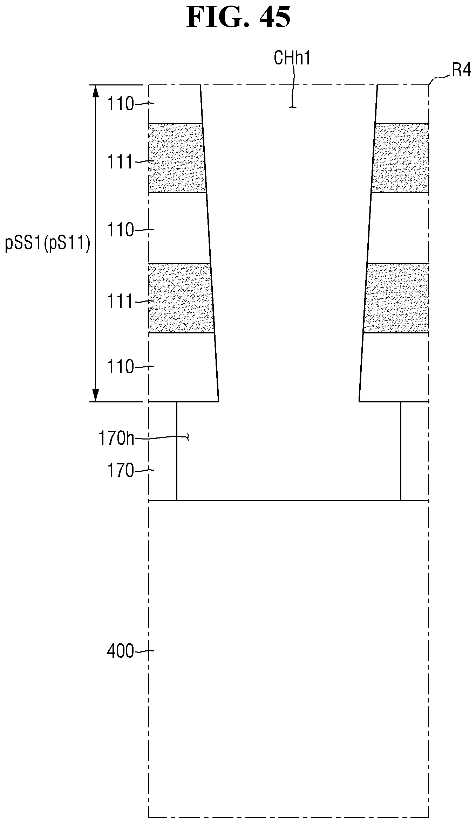

Referring to FIG. 45, a first channel hole CHh1 and a pad hole 170h are formed.

For example, the first preliminary channel pCH11, the second preliminary channel pCH12, the third preliminary channel pCH13 and the sacrificial pad 172 may be selectively removed.

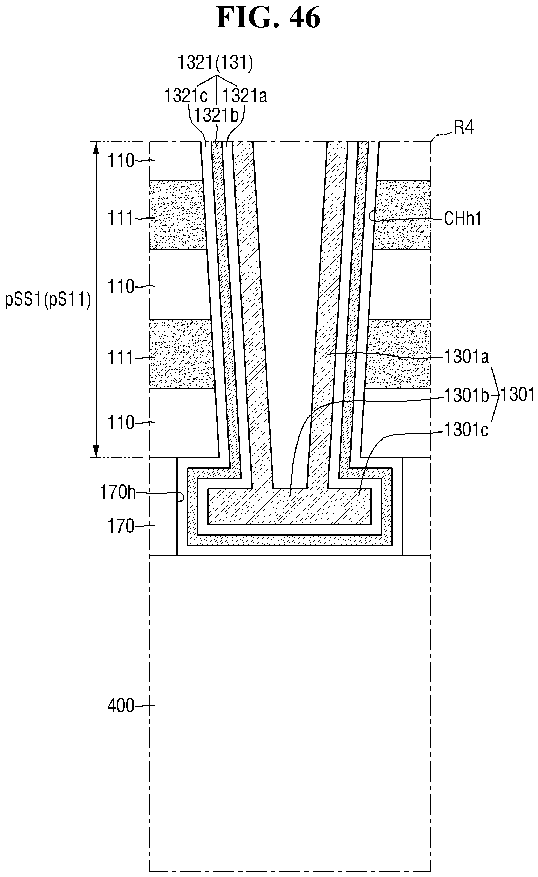

Referring to FIG. 46, a first dielectric layer 1321 and a first semiconductor layer 1301 are formed in the first channel hole CHh1 and the pad hole 170h. For example, the steps described with reference to FIG. 20 may be performed. Therefore, a first semiconductor layer 1301 including a first pillar portion 1301a, a second horizontal portion 1301b and a first pad portion 1301c may be formed.

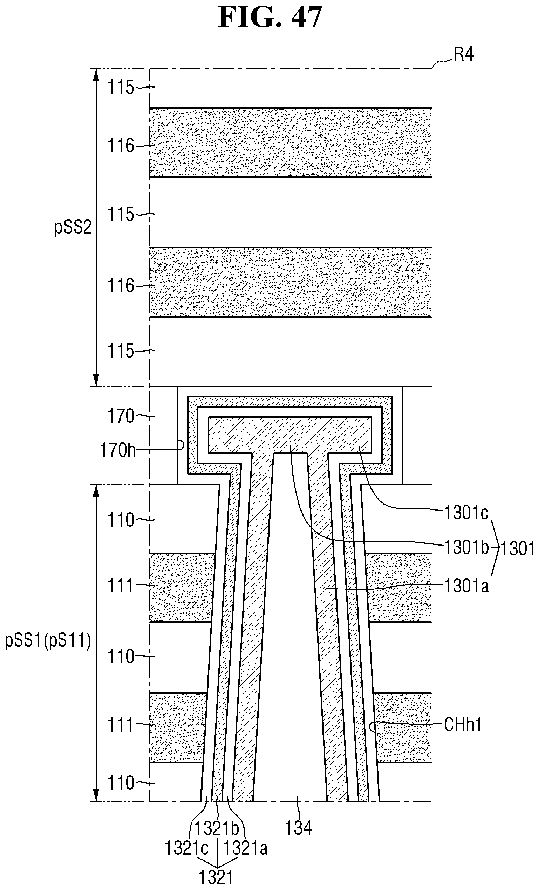

Referring to FIG. 47, a second preliminary stacked structure pSS2 is formed on the pad insulating layer 170. For example, the steps described with reference to FIGS. 21 to 23 may be performed.

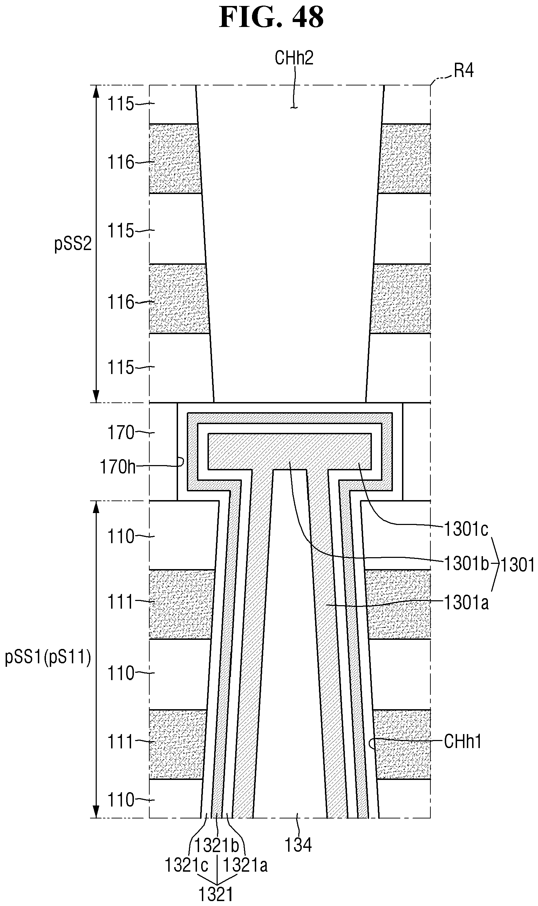

Referring to FIG. 48, a second channel hole CHh2 is formed in the second preliminary stacked structure pSS2.

The second channel hole CHh2 may pass through the second preliminary stacked structure pSS2. For example, the second channel hole CHh2 may expose the first dielectric layer 1321 in the pad hole 170h.

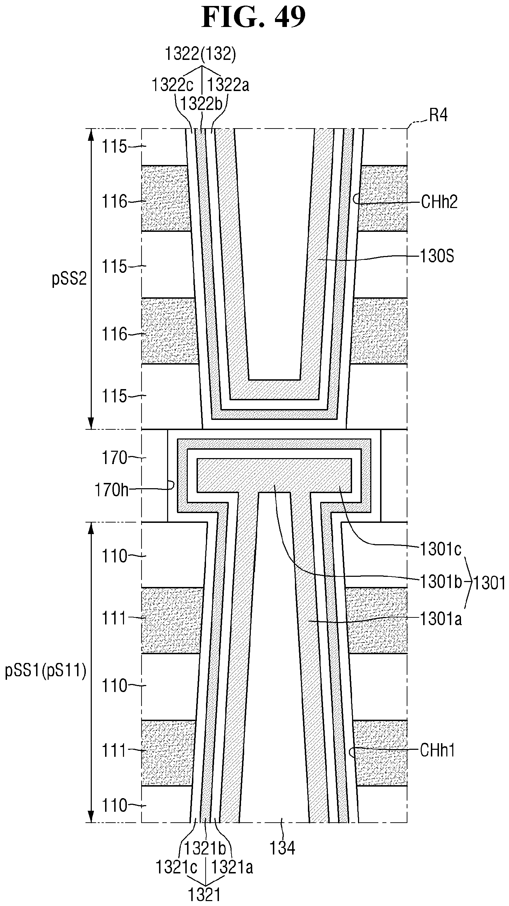

Referring to FIG. 49, a second dielectric layer 1322 and a sacrificial semiconductor layer 130S are sequentially formed in the second channel hole CHh2.

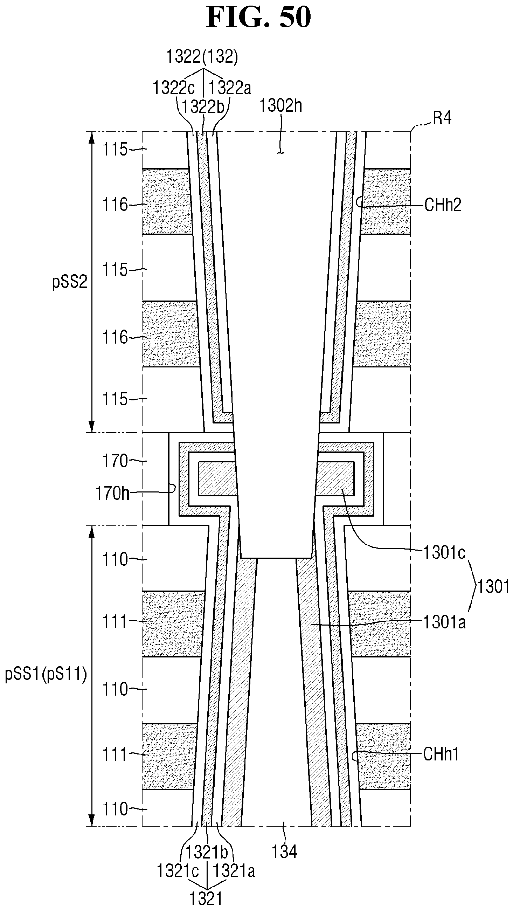

Referring to FIG. 50, a connection hole 1302h exposing the first semiconductor layer 1301 is formed in the second channel hole CHh2.

The connection hole 1302h may expose an upper portion of the first semiconductor layer 1301 by passing through a lower portion of the second dielectric layer 1322 and an upper portion of the first dielectric layer 1321. For example, the connection hole 1302h may expose the first pillar portion 1301a and the first pad portion 1301c.

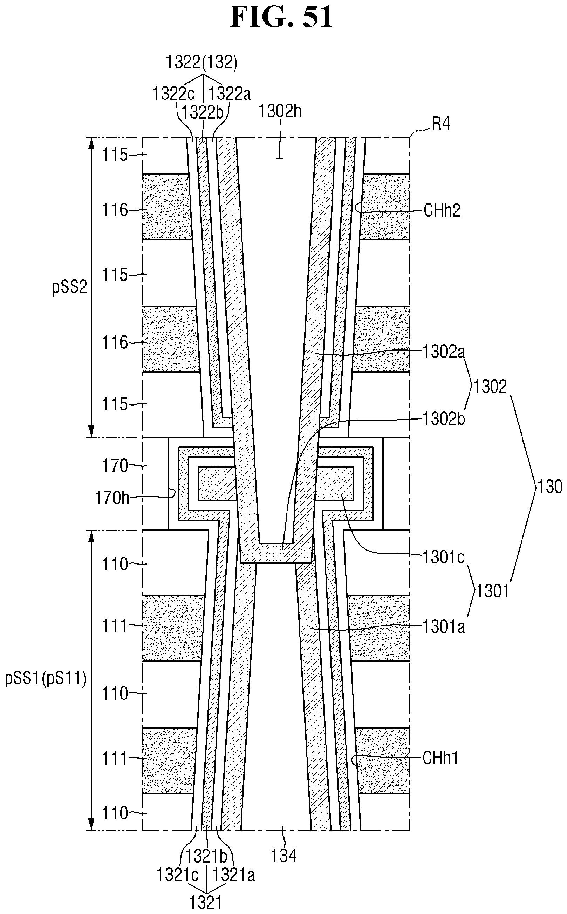

Referring to FIG. 51, the second semiconductor layer 1302 is formed in the connection hole 1302h.

Subsequently, the steps described with reference to FIGS. 30 to 34 and 4 may be performed. Therefore, the semiconductor memory device described with reference to FIGS. 10 and 11 may be fabricated.

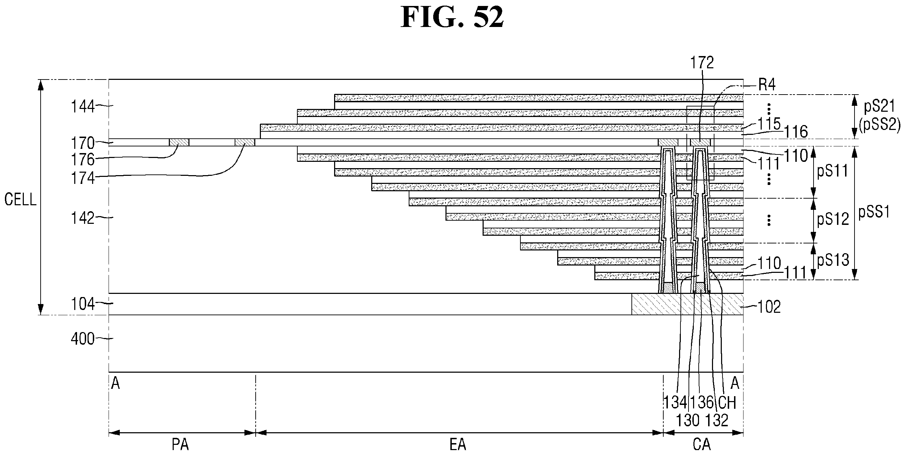

FIGS. 52 to 57 are views illustrating intermediate steps to describe a method for fabricating a semiconductor memory device according to an example embodiment. For convenience of description, redundant portions of those described above with reference to FIGS. 1 to 51 will be briefly described or omitted. For reference, FIG. 52 is a view illustrating an intermediate step to describe steps subsequent to FIG. 22.

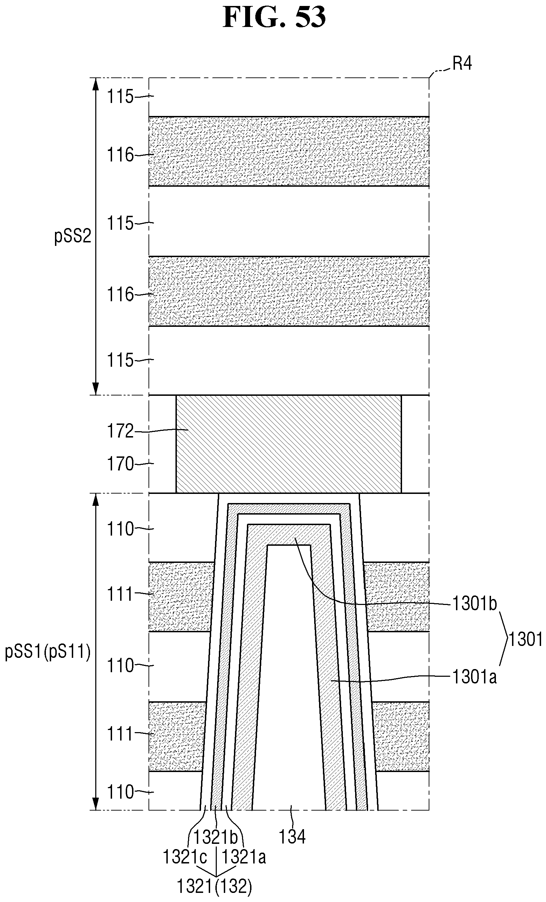

Referring to FIGS. 52 and 53, a pad insulating layer 170, a sacrificial pad 172, a second preliminary stacked structure pSS2 and a second interlayer insulating layer 144 are formed on the first preliminary stacked structure pSS1 and the first interlayer insulating layer 142.

For example, the base substrate 100 may be removed. A pad insulating layer 170 and a sacrificial pad 172 may be formed on an upper surface of the first preliminary stacked structure pSS1 and an upper surface of the first interlayer insulating layer 142. In some example embodiments, a first contact pad 174 and a second contact pad 176 may be further formed in the pad insulating layer 170 of the external area PA.

The second preliminary stacked structure pSS2 and the second interlayer insulating layer 144 may be formed on the pad insulating layer 170.

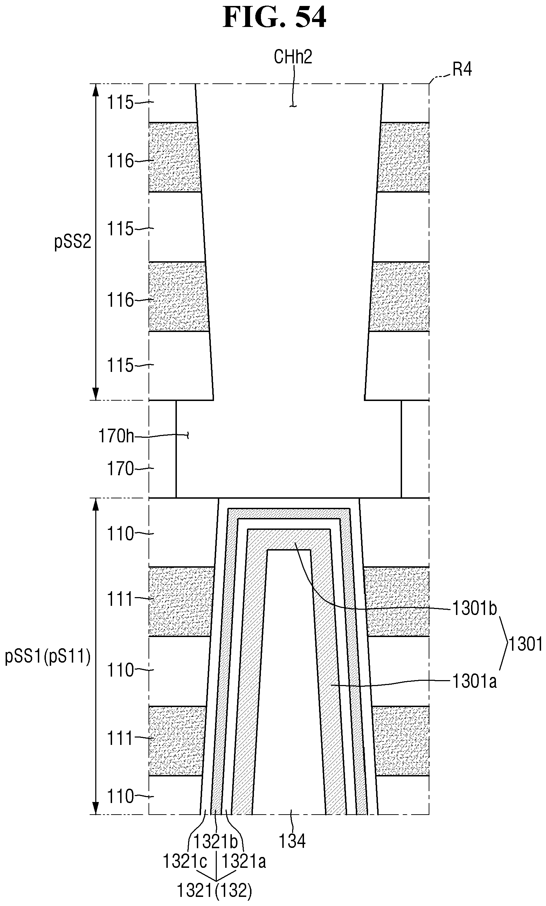

Referring to FIG. 54, the second channel hole CHh2 and the pad hole 170h are formed.

For example, the second channel hole CHh2 for exposing the sacrificial pad 172 by passing through the second preliminary stacked structure pSS2 may be formed. Subsequently, the sacrificial pad 172 exposed by the second channel hole CHh2 may be selectively removed.

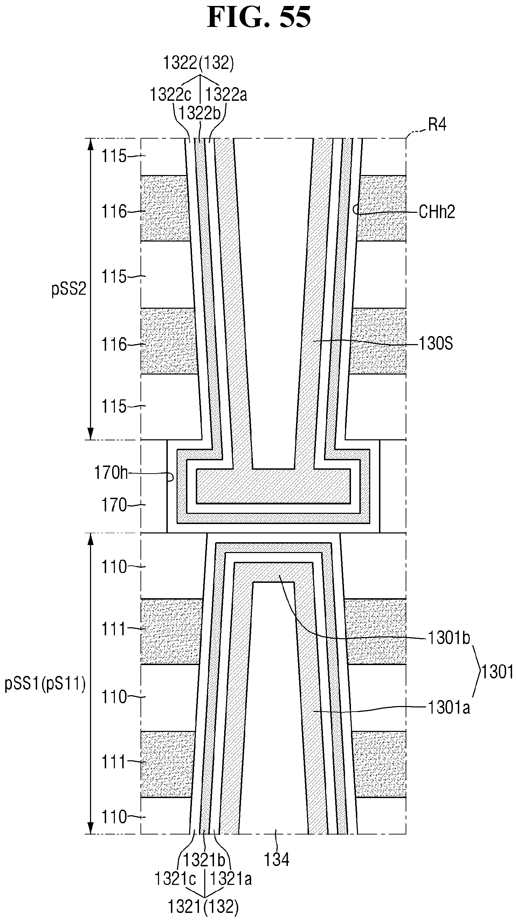

Referring to FIG. 55, a second dielectric layer 1322 and a sacrificial semiconductor layer 130S are formed in the second channel hole CHh2 and the pad hole 170h.

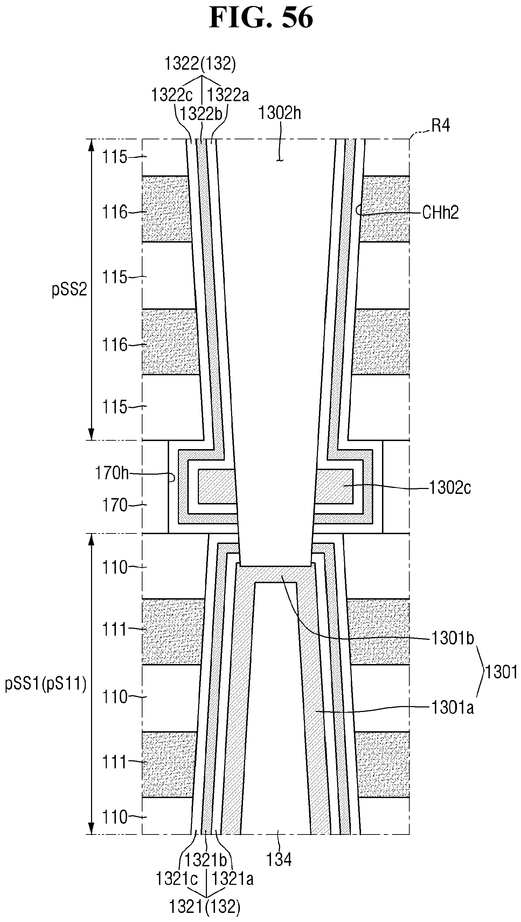

Referring to FIG. 56, a connection hole 1302h for exposing the first semiconductor layer 1301 is formed in the second channel hole CHh2.

The connection hole 1302h may expose an upper portion of the first semiconductor layer 1301 by passing through the lower portion of the second dielectric layer 1322 and the upper portion of the first dielectric layer 1321. For example, the connection hole 1302h may expose the second horizontal portion 1301b. In some example embodiments, a portion of the sacrificial semiconductor layer 130S remaining in the pad hole 170h may form a second pad portion 1302c.

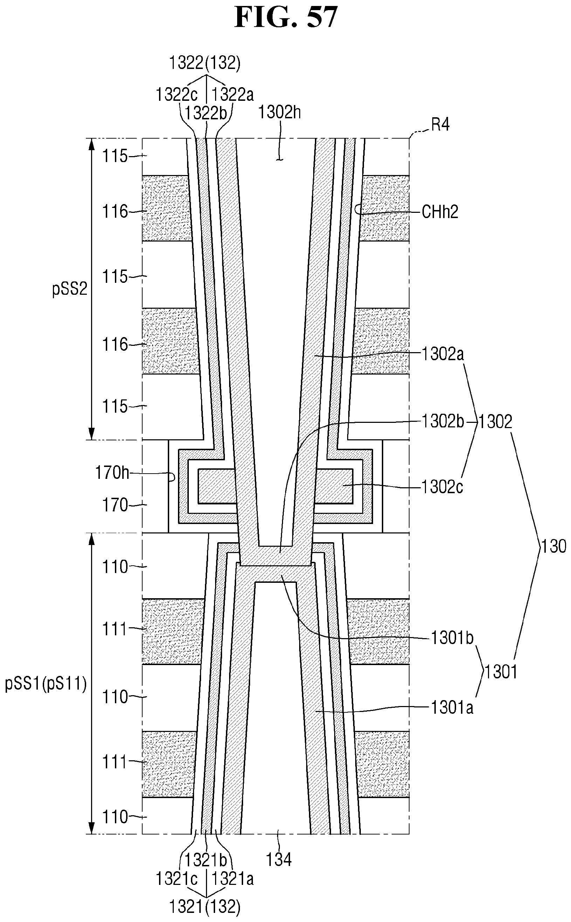

Referring to FIG. 57, the second semiconductor layer 1302 is formed in the connection hole 1302h.

Subsequently, the steps described above with reference to FIGS. 30 to 34 and 4 may be performed. As a result, the semiconductor memory device described above with reference to FIGS. 10 and 12 may be fabricated.

Hereinafter, an electronic system including a semiconductor memory device according to some example embodiments will be described with reference to FIGS. 1 to 60.

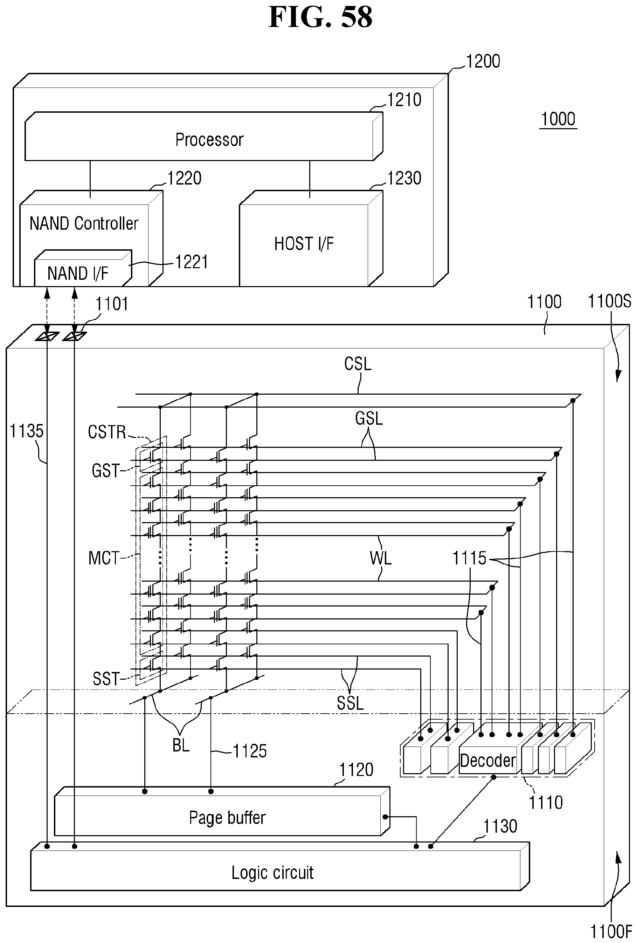

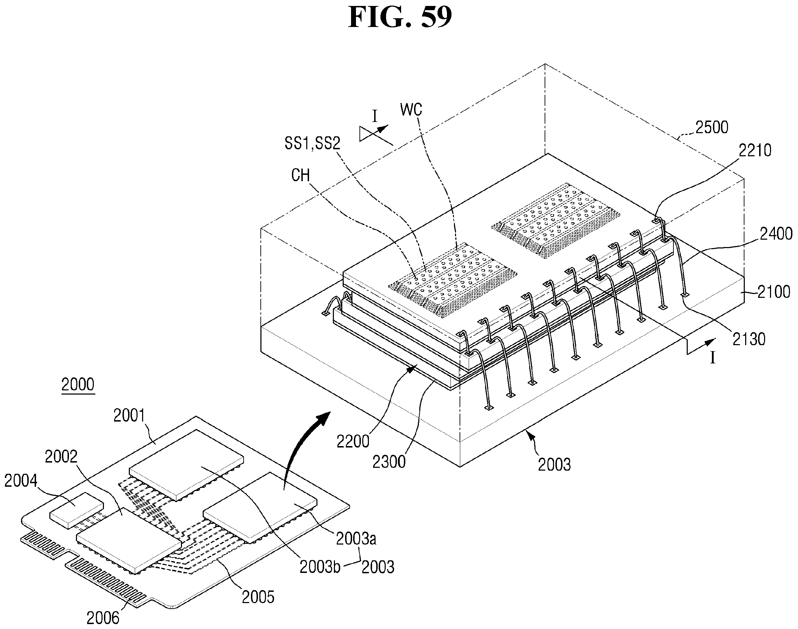

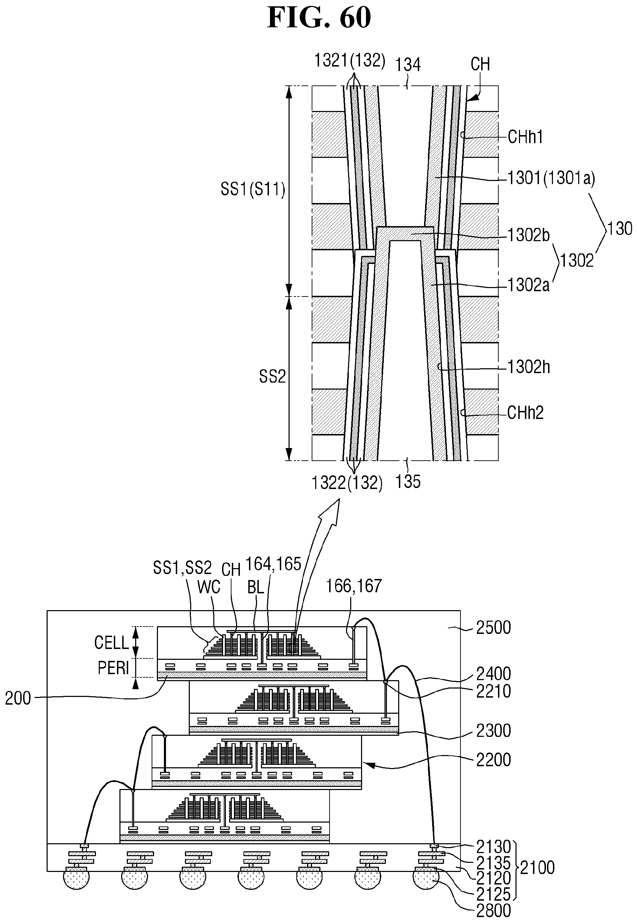

FIG. 58 is a block diagram illustrating an electronic system according to an example embodiment. FIG. 59 is a perspective view illustrating an electronic system according to an example embodiment. FIG. 60 is a schematic cross-sectional view taken along line I-I of FIG. 59. For convenience of description, redundant portions of those described above with reference to FIGS. 1 to 37 will be briefly described or omitted.

Referring to FIG. 58, an electronic system 1000 according to an example embodiment may include a semiconductor memory device 1100 and a controller 1200 electrically connected to the semiconductor memory device 1100. The electronic system 1000 may be a storage device including one or a plurality of semiconductor memory devices 1100 or an electronic device including the storage device. For example, the electronic system 1000 may be a solid state drive (SSD) device, a universal serial bus (USB), a computing system, a medical device or a communication device, which includes one or more semiconductor memory devices 1100.

The semiconductor memory device 1100 may be a nonvolatile memory device (e.g., NAND flash memory device), and for example, may include at least one of the semiconductor memory devices described with reference to FIGS. 1 to 17. The semiconductor memory device 1100 may include a first structure 1100F and a second structure 1100S on the first structure 1100F.

The first structure 1100F may be a peripheral circuit structure that includes a decoder circuit 1110 (e.g., the row decoder 33 of FIG. 1), a page buffer 1120 (e.g., the page buffer 35 of FIG. 1) and a logic circuit 1130 (e.g., the control logic 37 of FIG. 1). For example, the first structure 1100F may correspond to the peripheral circuit structure PERI described with reference to FIGS. 1 to 17.

The second structure 11005 may include a common source line CSL, a plurality of bit lines BL and a plurality of cell strings CSTR, which are described above with reference to FIG. 2. The cell strings CSTR may be connected to the decoder circuit 1110 through a word line WL, at least one string selection line SSL and at least one ground selection line GSL. In addition, the cell strings CSTR may be connected to the page buffer 1120 through the bit lines BL. For example, the second structure 11005 may correspond to the memory cell structure CELL described with reference to FIGS. 1 to 17.

In some embodiments, the common source line CSL and the cell strings CSTR may be electrically connected to the decoder circuit 1110 through first connection lines 1115 extended from the first structure 1100F to the second structure 11005.

In some example embodiments, the bit lines BL may be electrically connected to the page buffer 1120 through second connection lines 1125.

The semiconductor memory device 1100 may perform communication with the controller 1200 through an input/output pad 1101 electrically connected to the logic circuit 1130 (e.g., the control logic 37 of FIG. 1). The input/output pad 1101 may correspond to the conductive pad 390 described with reference to FIGS. 1 to 17. The input/output pad 1101 may be electrically connected to the logic circuit 1130 through an input/output connection line 1135 extended from the first structure 1100F to the second structure 1100S. For example, the connection line 1135 may correspond to the second through vias 166 and 167 described with reference to FIGS. 1 to 17.

The controller 1200 may include a processor 1210, a NAND controller 1220 and a host interface 1230. In some example embodiments, the electronic system 1000 may include a plurality of semiconductor memory devices 1100, and in this case, the controller 1200 may control the plurality of semiconductor memory devices 1100.

The processor 1210 may control the overall operation of the electronic system 1000 including the controller 1200. The processor 1210 may operate in accordance with predetermined firmware, and may access the semiconductor memory device 1100 by controlling the NAND controller 1220. The NAND controller 1220 may include a NAND interface 1221 that processes communication with the semiconductor memory device 1100. A control command for controlling the semiconductor memory device 1100, data to be written in the memory cell transistors MCT of the semiconductor memory device 1100, data to be read from the memory cell transistors MCT of the semiconductor memory device 1100, etc. may be transmitted through the NAND interface 1221. The host interface 1230 may provide a communication function between the electronic system 1000 and an external host. When the control command is received from the external host through the host interface 1230, the processor 1210 may control the semiconductor memory device 1100 in response to the control command.

Referring to FIGS. 59 and 60, an electronic system 2000 according to some embodiments may include a main board 2001, a main controller 2002 packaged on the main board 2001, one or more semiconductor packages 2003 and a DRAM 2004. The semiconductor package 2003 and the DRAM 2004 may be connected to the main controller 2002 by wiring patterns 2005 formed in the main board 2001.

The main board 2001 may include a connector 2006 that includes a plurality of pins coupled to the external host. The number and arrangement of the plurality of pins in the connector 2006 may be varied depending on the communication interface between the electronic system 2000 and the external host. In some example embodiments, the electronic system 2000 may perform communication with the external host in accordance with any one of interfaces such as a Universal Serial Bus (USB), a Peripheral Component Interconnect Express (PCI-Express), Serial Advanced Technology Attachment (SATA) and M-Phy for Universal Flash Storage (UFS). In some embodiments, the electronic system 2000 may operate by a power source supplied from the external host through the connector 2006. The electronic system 2000 may further include a power management integrated circuit (PMIC) that distributes the power source supplied from the external host to the main controller 2002 and the semiconductor package 2003.

The main controller 2002 may write data in the semiconductor package 2003 or read the data from the semiconductor package 2003, and may improve the operating speed of the electronic system 2000.

The DRAM 2004 may be a buffer memory for mitigating a speed difference between the semiconductor package 2003 that is a data storage space and the external host. Also, the DRAM 2004 included in the electronic system 2000 may operate as a kind of a cache memory, and may provide a space for temporarily storing data in a control operation for the semiconductor package 2003. When the DRAM 2004 is included in the electronic system 2000, the main controller 2002 may further include a DRAM controller for controlling the DRAM 2004, in addition to the NAND controller for controlling the semiconductor package 2003.

The semiconductor package 2003 may include a first semiconductor package 2003a and a second semiconductor package 2003b, which are spaced apart from each other. Each of the first semiconductor package 2003a and the second semiconductor package 2003b may be a semiconductor package that includes a plurality of semiconductor chips 2200. Each of the first semiconductor package 2003a and the second semiconductor package 2003b may include a package substrate 2100, semiconductor chips 2200 on the package substrate 2100, adhesive layers 2300 disposed on lower surfaces of the respective semiconductor chips 2200, a connection structure 2400 for electrically connecting the semiconductor chips 2200 with the package substrate 2100, and a molding layer 2500 covering the semiconductor chips 2200 and the connection structure 2400 on the package substrate 2100.

The package substrate 2100 may be a printed circuit board that includes package upper pads 2130. Each semiconductor chip 2200 may include an input/output pad 2210. The input/output pad 2210 may correspond to the input/output pad 1101 of FIG. 58.

In some example embodiments, the connection structure 2400 may be a bonding wire for electrically connecting the input/output pad 2210 with the package upper pads 2130. Therefore, in each of the first semiconductor package 2003a and the second semiconductor package 2003b, the semiconductor chips 2200 may be electrically connected to each other in a bonding wire manner, and may be electrically connected to the package upper pads 2130 of the package substrate 2100. In some example embodiments, in each of the first semiconductor package 2003a and the second semiconductor package 2003b, the semiconductor chips 2200 may be electrically connected to each other by a connection structure that includes a through silicon via (TSV), instead of the connection structure 2400 of the bonding wire manner.

In some example embodiments, the main controller 2002 and the semiconductor chips 2200 may be included in one package. In some example embodiments, the main controller 2002 and the semiconductor chips 2200 may be packaged on a separate interposer substrate different from the main board 2001, and the main controller 2002 may be connected with the semiconductor chips 2200 by a wire formed in the interposer substrate.

In some example embodiments, the package substrate 2100 may be a printed circuit board. The package substrate 2100 may include a package substrate body portion 2120, package upper pads 2130 disposed on an upper surface of the package substrate body portion 2120, lower pads 2125 disposed on a lower surface of the package substrate body portion 2120 or exposed through the lower surface, and internal wires 2135 electrically connecting the upper pads 2130 with the lower pads 2125 inside the package substrate body portion 2120. The package upper pads 2130 may be electrically connected to the connection structures 2400. The lower pads 2125 may be connected to the wiring patterns 2005 of the main board 2001 of the electronic system 2000 through conductive connectors 2800 as shown in FIG. 59.

In the electronic system according to some example embodiments, each of the semiconductor chips 2200 may include the semiconductor memory device described with reference to FIGS. 1 to 17. For example, each of the semiconductor chips 2200 may include a memory cell structure CELL and a peripheral circuit structure PERI. Illustratively, the memory cell structure CELL may include a first stacked structure SS1, a second stacked structure SS2, a channel structure CH, a cutting structure WC, a bit line BL, first through vias 164 and 165 and second through vias 166 and 167, which are described with reference to FIGS. 3 to 7.

Any functional blocks shown in the figures and described above may be implemented in processing circuitry such as hardware including logic circuits, a hardware/software combination such as a processor executing software, or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

While the present inventive concepts have been particularly shown and described with reference to some example embodiments thereof, it will be understood by those of ordinary skill in the art that various changes in form and details may be made therein without departing from the spirit and scope of the present inventive concepts as defined by the following claims. It is therefore desired that the present example embodiments be considered in all respects as illustrative and not restrictive, reference being made to the appended claims rather than the foregoing description to indicate the scope of the inventive concepts.

## Claims

1. A semiconductor memory device comprising:
a first stacked structure including a plurality of first gate electrodes sequentially stacked and spaced apart from each other;
a second stacked structure on the first stacked structure, the second stacked structure including a plurality of second gate electrodes sequentially stacked and spaced apart from each other; and
a channel structure extended in a vertical direction to pass through the first stacked structure and the second stacked structure,
wherein the channel structure includes,
a channel layer including a first pillar portion crossing the plurality of first gate electrodes, a second pillar portion crossing the plurality of second gate electrodes, and a horizontal portion extended along a plane crossing the vertical direction, the horizontal portion connecting the first pillar portion and the second pillar portion, and
a data storage layer extending along an outer side of the channel layer.

2. The semiconductor memory device of claim 1, wherein
a width of the first pillar portion is reduced as the first pillar portion is directed toward the second stacked structure, and
a width of the second pillar portion is reduced as the second pillar portion is directed toward the first stacked structure.

3. The semiconductor memory device of claim 1, wherein
the plurality of first gate electrodes are stacked on an upper surface of the second stacked structure in a stepwise shape, and
the plurality of second gate electrodes are stacked on a lower surface of the first stacked structure in a stepwise shape.

4. The semiconductor memory device of claim 1, wherein
the first stacked structure includes a first stack and a second stack, the first stack and the second stack being sequentially stacked on the second stacked structure,
each of the first stack and the second stack includes the plurality of first gate electrodes, and
a width of the channel structure in the first stack is greater than a width of the channel structure in the second stack, at a boundary surface between the first stack and the second stack.

5. The semiconductor memory device of claim 1, wherein the channel structure further includes:
a first filling insulating layer at least partially filling an inside of the first pillar portion; and
a second filling insulating layer at least partially filling an inside of the second pillar portion; and
wherein the horizontal portion separates the first filling insulating layer from the second filling insulating layer.

6. The semiconductor memory device of claim 5, wherein the channel structure further includes:
a first channel pad connected to one end of the first pillar portion, on the first filling insulating layer; and
a second channel pad connected to one end of the second pillar portion, on the second filling insulating layer.

7. The semiconductor memory device of claim 1, wherein the data storage layer includes:
a first dielectric layer including a first tunneling insulating layer, a first charge storage layer and a first blocking insulating layer that are sequentially stacked on an outer side of the first pillar portion; and
a second dielectric layer including a second tunneling insulating layer, a second charge storage layer and a second blocking insulating layer that are sequentially stacked on an outer side of the second pillar portion, and
wherein the second blocking insulating layer separates the first charge storage layer from the second charge storage layer.

8. The semiconductor memory device of claim 1, further comprising:
a pad insulating layer interposed between the first stacked structure and the second stacked structure,
wherein the channel layer further includes a pad portion extended along a plane crossing the vertical direction in the pad insulating layer,
a width of the pad portion is greater than a width of the first pillar portion, and
the second pillar portion is connected to the pad portion.

9. The semiconductor memory device of claim 1, further comprising:
a source structure connected to the first pillar portion, on the first stacked structure; and
a bit line connected to the second pillar portion, on the second stacked structure.

10. The semiconductor memory device of claim 1, further comprising:
a peripheral circuit structure including a peripheral circuit substrate and a peripheral circuit element on the peripheral circuit substrate,
wherein the second stacked structure is interposed between the first stacked structure and the peripheral circuit structure.

11. A semiconductor memory device comprising:
a peripheral circuit structure including a peripheral circuit substrate and a peripheral circuit element on the peripheral circuit substrate;
a first stacked structure on the peripheral circuit structure, the first stacked structure including a plurality of first gate electrodes sequentially stacked and spaced apart from each other;
a second stacked structure between the peripheral circuit structure and the first stacked structure, the second stacked structure including a plurality of second gate electrodes sequentially stacked and spaced apart from each other;
a channel layer extending in a vertical direction and passing through the first stacked structure and the second stacked structure, the channel layer including a first semiconductor layer crossing the plurality of first gate electrodes and a second semiconductor layer crossing the plurality of second gate electrodes;
a data storage layer including
a first dielectric layer interposed between the first stacked structure and the first semiconductor layer, and
a second dielectric layer interposed between the second stacked structure and the second semiconductor layer;
a source structure connected to the first semiconductor layer, on the first stacked structure; and
a bit line connected to the second semiconductor layer and between the peripheral circuit structure and the second stacked structure,
wherein a width of the first semiconductor layer is reduced as the first semiconductor layer is directed toward the second stacked structure,
a width of the second semiconductor layer is reduced as the second semiconductor layer is directed toward the first stacked structure, and
the second semiconductor layer includes a horizontal portion, the horizontal portion extending along a plane crossing the vertical direction and connected to the first semiconductor layer.

12. The semiconductor memory device of claim 11, wherein the horizontal portion is in the first stacked structure.

13. The semiconductor memory device of claim 11, further comprising:
a pad insulating layer interposed between the first stacked structure and the second stacked structure,
wherein the first semiconductor layer includes a pad portion extending along a plane crossing the vertical direction in the pad insulating layer,
a width of the pad portion is greater than a width of the second semiconductor layer at the plane, and
the second semiconductor layer is connected to the pad portion.

14. The semiconductor memory device of claim 11, wherein each of the first semiconductor layer and the second semiconductor layer includes a polysilicon (poly-Si) layer.

15. The semiconductor memory device of claim 11, wherein each of the first dielectric layer and the second dielectric layer includes a tunneling insulating layer, a charge storage layer and a blocking insulating layer that are sequentially stacked on an outer side of the channel layer.
